# EUROPEAN PATENT APPLICATION

(11) **EP 0 834 912 A2**
(43) Date of publication of application: **08.04.1998**
(21) Application number: 97307794.4
(22) Date of filing: 02.10.1997
(51) Int. Cl.: H01L 21/3205, H01L 27/108

(54) **Dry-etching-free process for high dielectric and ferroelectric memory cell capacitor**

(30) Priority: 02.10.1996 JP 281527/96
(71) Applicant: TEXAS INSTRUMENTS INCORPORATED, Dallas, Texas 75243 (US)
(72) Inventor: Numata, Ken, Plano Texas 75093 (US); Aoki, Katsuhiro, Tsuchiura IB Japan 300 (JP); Fukuda, Yukio, Toukai Naka Gun IB Japan 319-11 (JP); Nishimura, Akitoshi, Plano Texas 75024 (US)
(74) Representative: Harris, Ian Richard

(57) **Abstract**

Aims to provide a dielectric capacitor and a dielectric memory device wherein residue is minimal, electric current leakage is minimal, the shape is superior, is suited for enhancing the integration, and has favorable insulation property and an economical and efficient manufacturing method. Dielectric capacitors CAP(1)-CAP(4)) which have bottom electrode 29, dielectric films 20 and 34 formed by contacting this bottom electrode, top electrode 23 formed by contacting this dielectric film, and insulation films 21 and 33 provided by contacting the periphery of bottom electrode 29, and wherein elimination part 17 is formed beforehand in said insulation film, bottom electrode 29 adhered at least within said elimination part is formed into smooth concave surface 29a or convex surface 29b according to etch back or chemical-mechanical polishing process, and dielectric film 20 is formed on this surface, dielectric memory devices M-CEL(1)-M-CEL(4) which have these dielectric capacitors, and a manufacturing method for these capacitors or memory cells.

## Description

### FIELD OF THE INVENTION

The present invention relates to a dielectric capacitor (in particular, a high-dielectric capacitor or a ferroelectric capacitor), a dielectric memory device (in particular, a semiconductor memory which uses a high-dielectric capacitor or a ferroelectric capacitor), and the manufacturing method for these.

### BACKGROUND OF THE INVENTION

In recent years, demand has been growing for a high-dielectric memory device or a ferroelectric memory device which has a high-dielectric capacitor or a ferroelectric capacitor as a semiconductor memory. A High-dielectric capacitor uses A high-dielectric substance such as BST ((Sr,Ba) TiO₃) as the dielectric film and forms the cell capacity of the memory cell in a DRAM (Dynamic Random Access Memory).

Also, by forming a cell capacitor using a ferroelectric substance such as PZT (Pb(Zr,Ti)O₃) as the dielectric film, a memory cell of a FRAM (Ferroelectric Random Access Memory) is composed, which is a nonvolatile memory element using the remanence characteristic thereof.

Below, a high-dielectric memory cell having a high-dielectric capacitor will be explained in detail.

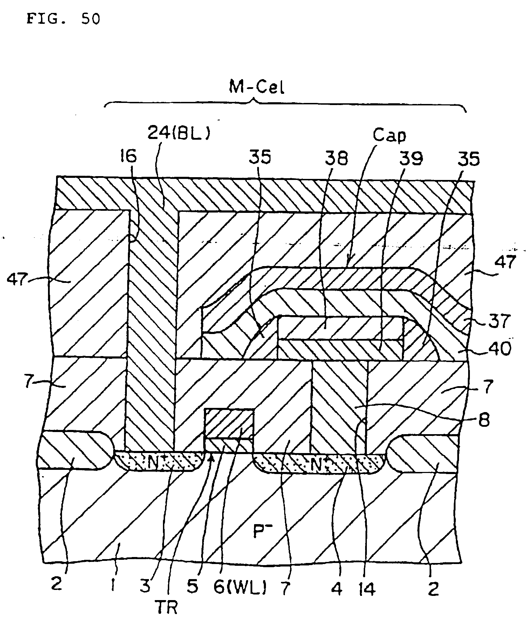

In a conventional high-dielectric capacitor (Cap) shown in FIG. 50, a Pt/TiN/Ti or Ir/TiN/Ti structure is used in which Pt or Ir as bottom electrode 38 is laminated on TiN/Ti as diffusion-preventing barrier metal layer 39 of the electrode compositional part. On this laminated body, high-dielectric thin film 40 is formed by sputtering or chemical vapor deposition (CVD), and Pt or Ir is formed as top electrode 37 in more or less the same pattern.

In this case, spacer (side wall for securing insulation) 35 is formed on the side surface of barrier metal layer 39 and bottom electrode 38 composed of Pt or Ir.

Also, high-dielectric film 40 which composes the high-dielectric capacitor is composed of a BST film, namely, a (Ba,Sr)TiO₃ film formed by sputtering, etc. Also, bottom electrode 38 is connected to the silicon substrate side via polysilicon layer (plug) 8 as the storage node embedded in contact hole 14 of insulation film 7 such as SiO₂, etc.

When the memory cell of a DRAM having this high-dielectric capacitor is explained, an element region partitioned with field oxide film 2 is formed on one principal surface of, for example, P⁻-type silicon substrate 1. Here, memory cell (M-Cel) composed of a high-dielectric capacitor (Cap) and transfer gate (TR) composed of a MOS transistor are provided.

In transfer gate (TR), for example, N⁺-type drain region 3 and N⁺-type source region 4 are formed by impurity diffusion, word line 6 (WL) is provided between these two regions via gate oxide film 5, and bit line 24 (BL) is connected to drain region 3 via contact hole 16 of insulation films 7 and 47 such as SiO₂, etc.

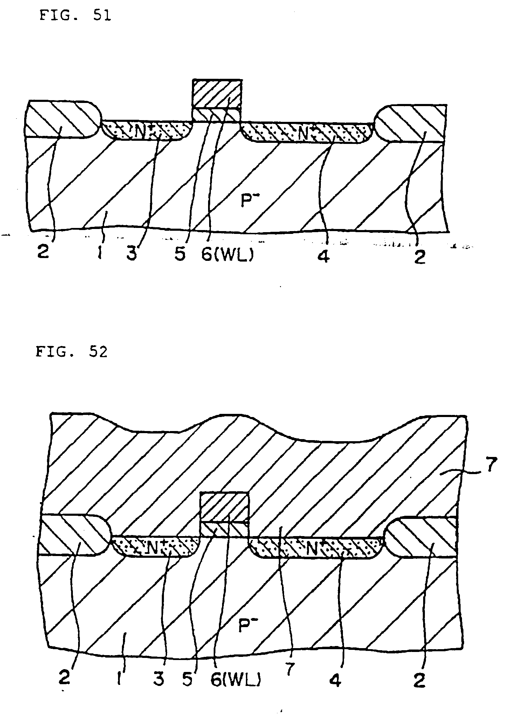

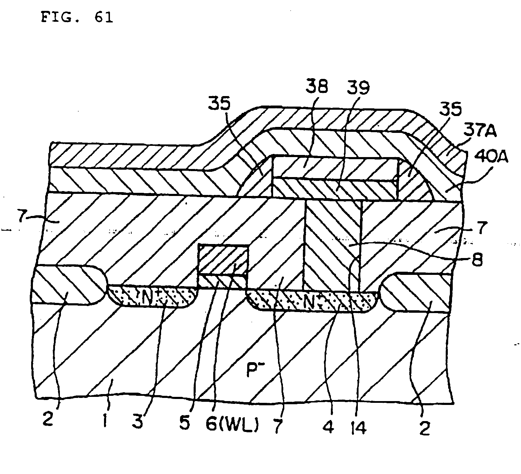

Here, the fabrication process for capacitor (Cap) and memory cell (M-Cel) shown in FIG. 50 will be explained with regards to FIGS. 51-64. Here, it is the CUB (Cell Under Bit line) type.

First, field oxide film 2 is formed by selective oxidation on P⁻-type silicon substrate (wafer) 1, gate oxide film 5 is formed by thermal oxidation, polysilicon word line 6 (WL) is formed by chemical vapor deposition, and after patterning these, N⁺-type drain region 3 and source region 4 are formed by thermal diffusion of N⁺-type impurities such as As, etc., as shown in FIG. 51.

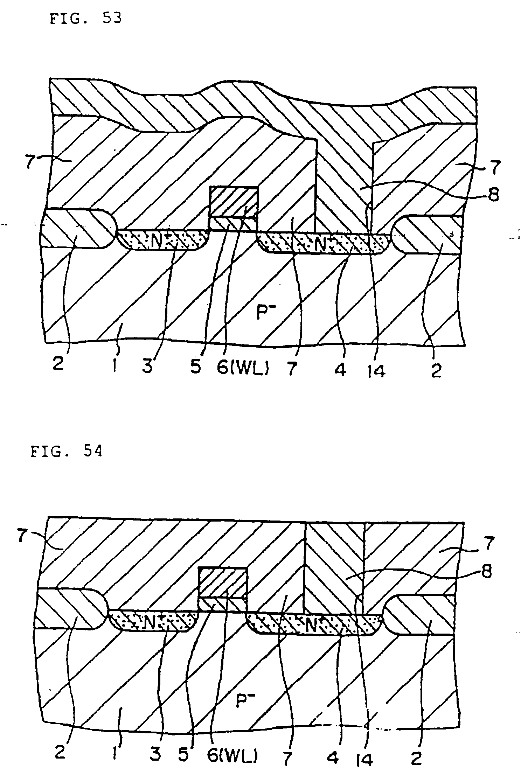

Then after depositing SiO₂ insulation layer 7 on the entire surface by chemical vapor deposition, insulation layer 7 is etched using a photoresist mask (not shown in the figure) as in FIG. 52; contact hole 14 is formed into a prescribed shape on source region 4 as shown in FIG. 53.

Next, polysilicon layer 8 is adhered in contact hole 14 so as to contact source region 4 by chemical vapor deposition.

Next, polysilicon layer 8 as the storage node and SiO₂ layer 7 are etched back according to plasma etching or a chemical-mechanical polishing process (CMP/planarization) to make the surface flat, as shown in FIG. 54.

Here, if said flattening process is not executed, namely, when the top layer is laminated as with a difference in level, the covering property of the top layer degrades and causes current leakage and film separation.

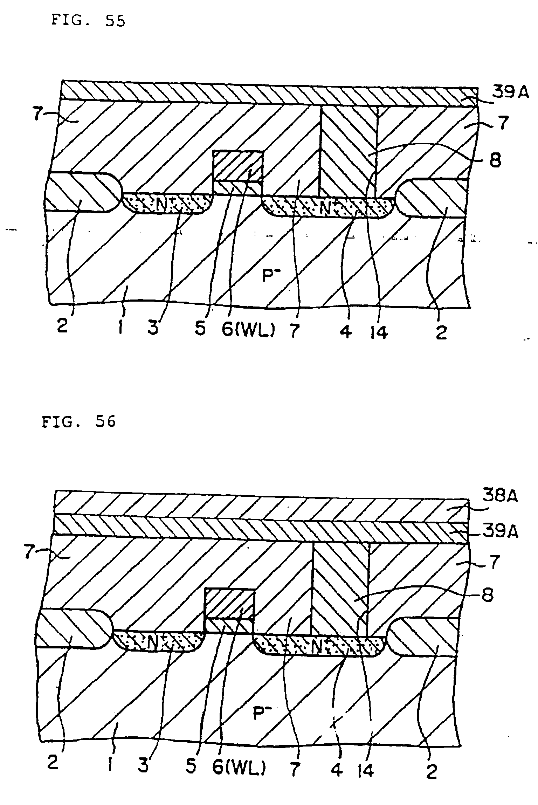

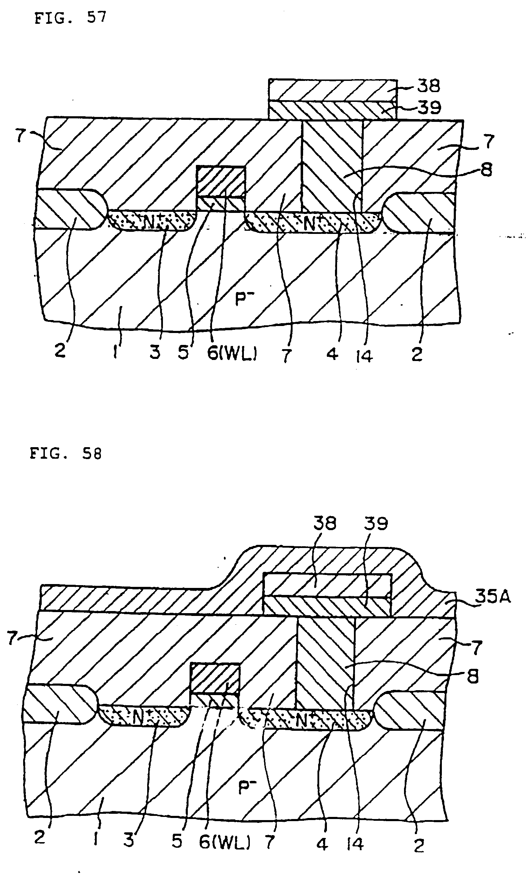

Next, after sputtering or vapor depositing barrier metal layer material 39A composed of TiN layer and Ti adhesive layer as shown in FIG. 55 on said flattened surface, bottom electrode material layer 38A composed of Pt is sputtered or vapor deposited as shown in FIG. 56.

Next, bottom electrode 38 and barrier metal layer 39 are etched into approximately the same pattern using a photoresist mask (not shown in the figure) as shown in FIG. 57.

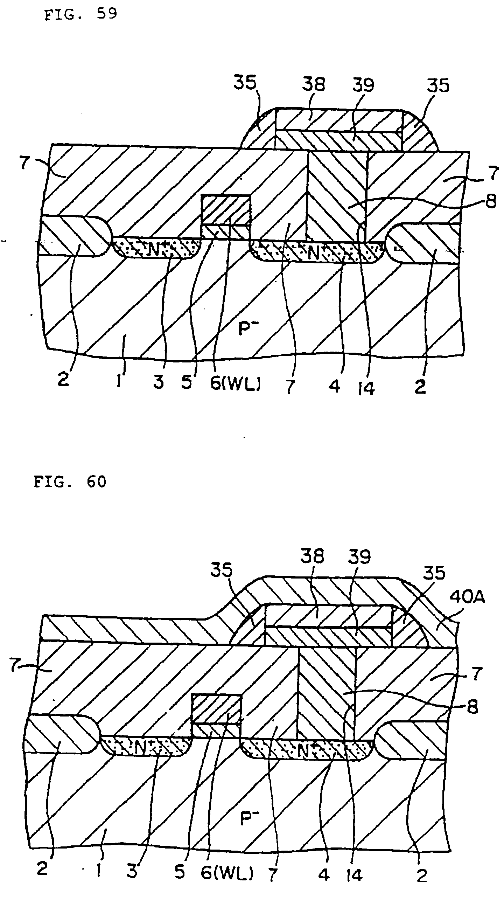

Next, by executing etch back by anisotropic plasma etching after forming a film of SiO₂ 35A for forming a spacer (side wall for securing insulation) according to chemical vapor deposition as shown in FIG. 58, SiO₂ spacer 35 of a prescribed shape is formed as a side wall as shown in FIG. 59.

Next, a film of high-dielectric material 40A composed of BST (Ti (Ba,Sr)O₃ film) is formed by sputtering or vapor deposition as shown in FIG. 60. Then on this, top electrode material layer 37A composed of Pt or Ir is sputtered or vapor deposited as shown in FIG. 60.

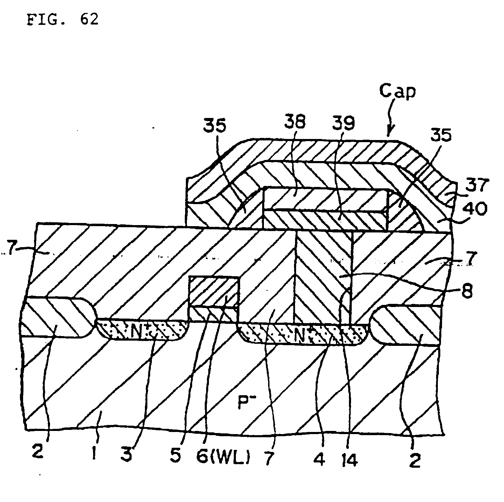

Next, top electrode 37 and high-dielectric film 40 are formed into a prescribed shape by patterning according to etching using a photoresist mask (not shown in the figure) as shown in FIG. 62.

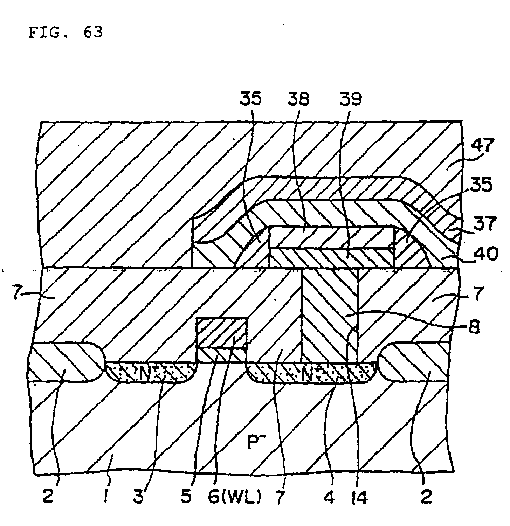

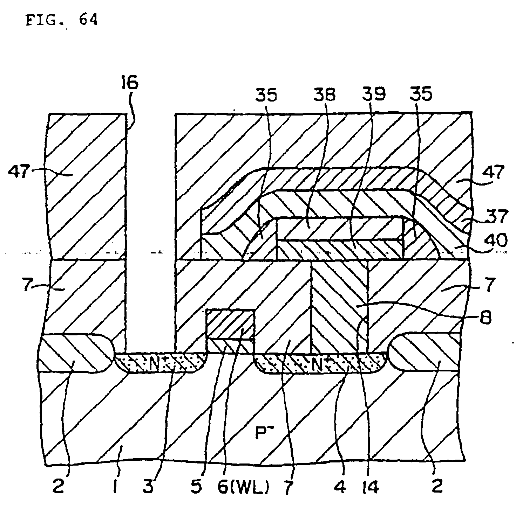

Next, after adhering insulation layer 47 of SiO₂, etc., by chemical vapor deposition as shown in FIG. 63, contact hole 16 is formed into a prescribed shape according to plasma etching as shown in FIG. 64. Then, bit line 24 (BL) is connected to drain region 3 via this contact hole 16, and high-dielectric memory cell (M-Cel), which is integrated with high-dielectric capacitor (Cap) shown in FIG. 50, is fabricated.

A high-dielectric memory cell having a high-dielectric capacitor is fabricated in the manner noted above. However, it is also possible to fabricate a ferroelectric memory cell having a ferroelectric capacitor which uses PZT as the dielectric substance according to approximately the same process noted above.

In said memory cell and fabrication method thereof, a rare metal such as platinum (Pt) is normally used as bottom electrode 38 and top electrode 37 for the high-dielectric or ferroelectric capacitor. However, needing to form each electrode by etching this rare metal, as shown in FIGS. 57 and 62, is a problem.

It is generally not easy to etch a rare metal.

DRAM or FRAM composed of memory cells having a high-dielectric or ferroelectric capacitor is considered to be that in which the integration will be enhanced in the future to have a bit count of over 256 megabits. Also, bottom electrode 38 needs to be separated for each memory cell, thus the typical size thereof becomes 0.5 µm or less.

For example, in platinum, which is representative as an electrode material, wet etching by aqua regia is possible, but it is difficult to apply this wet etching to etching of bottom electrode 38. Namely, etching according to wet etching is isotropic, so there is a tendency for under etching to be generated. When wet etching is used in said bottom electrode of fine structure, the size deviates from the design value and the reproducibility is poor. To prevent this, a margin is provided for mask conformity during the etching, but this decreases the integration.

Also, dry etching of platinum has been studied in recent years, but a platinum compound of high vapor pressure has not been found, so it is not easy to select a reactive etching gas.

Dry etching of platinum presently being executed is an etching based on the physical sputtering method and utilizes the principle of reverse sputtering. However, this etching based on sputtering is not a chemical method, so it is very difficult to enhance the selection ratio (ratio of the etching speed of the platinum with respect to the etching speed of the photoresist) of the platinum and the photoresist as the etching mask.

Also, in this etching by sputtering, residue composed of a polymer such as an organic material containing platinum, etc., is often generated on the side surface of the electrode. This residue is difficult to remove by chemical cleansing, so when a dielectric memory cell is fabricated with this residue adhered to the side wall of the electrode, etc., there is a tendency for electrical defects such as current leakage, etc., to occur due to this residue.

Furthermore, in said conventional dielectric memory cell fabrication process, it is necessary to execute patterning twice to form bottom electrode 38 and top electrode 37, composed of a rare metal such as platinum, etc., (FIGS. 57, 62) . Thus, [additional] cost and manufacturing time are necessary.

The objective of the present invention is to provide a dielectric capacitor and a dielectric memory device which sufficiently satisfy the requirements of enhanced integration, favorable insulation property, and lack of residue, as well as a method for manufacturing these economically and efficiently.

### SUMMARY OF THE INVENTION

Namely, the present invention relates to a dielectric capacitor and a dielectric memory device (e.g., DRAM, FRAM: hereafter the same) having this dielectric capacitor in the memory cell, which have a first electrode (e.g., bottom electrode composed of a rare metal such as Pt, Ir, etc.: hereafter the same), a dielectric film (e.g., high-dielectric film such as BST, etc., or ferroelectric film such as PZT, etc.: hereafter the same) formed by contacting said first electrode, a second electrode (e.g., top electrode composed of a rare metal such as Pt, Ir, etc.: hereafter the same) formed by contacting said dielectric film, and an insulation film (e.g., silicon oxide film, titanium oxide film: hereafter the same) provided by contacting the periphery of said first electrode. In this insulation film, an elimination part (e.g., through-hole which was etched: hereafter the same) is formed into a prescribed pattern by etching, etc. At least the first electrode which was adhered within this elimination part is processed into a prescribed shape by chemical-mechanical polishing process (CMP) or etch back, etc., and said dielectric film is formed on this surface.

Also, the present invention provides a manufacturing method for a dielectric capacitor which includes forming an elimination part by patterning the insulation film, adhering a material for the first electrode at least within said elimination part, creating said first electrode into said first electrode of prescribed shape so as to have a smooth surface by treating the material for the surface of said first electrode with a chemical-mechanical polishing process or etch back, etc., and forming a dielectric film on this surface when manufacturing a dielectric capacitor which has a first electrode, a dielectric film formed by contacting said first electrode, a second electrode formed by contacting said dielectric film, and an insulation film provided by contacting the periphery of said first electrode, and a manufacturing method for a dielectric memory device which fabricates said dielectric capacitor in the memory cell according to the aforementioned manufacturing method.

According to the present invention, an elimination part is patterned in the insulation film so it is not necessary to pattern the first electrode. Namely, by treating the electrode material adhered to said elimination part with a chemical-mechanical polishing process or etch back, etc., a first electrode of prescribed shape can be obtained without patterning the first electrode by etching. Therefore, even if the first electrode is composed of a rare metal such as Pt, etc., wet etching or dry etching this is not necessary, as in the conventional method, and there is no residue which is generated when etching. In addition, it is possible to obtain high integration by making the electrode size small. Also, the first electrode is surrounded by an insulation film, so the top electrode and the dielectric film can be separated favorably between the cells, and even the top electrode and the bottom electrode can be favorably separated. Thus, a dielectric capacitor and a memory cell of minimal current leakage and favorable insulation can be obtained. Also, the second electrode can be processed into a prescribed pattern with a margin by wet etching.

Also, according to the present invention, by forming an elimination part of the insulation film into the electrode shape beforehand, the first electrode can be formed into a prescribed shape just by treating the electrode material from the surface. Thus, patterning of the first electrode by etching becomes unnecessary, which means that the [number of] processes for patterning the electrode in which etching is difficult is reduced by one, so economical and highly efficient manufacture is possible, reducing cost and manufacturing time, etc.

Patterning of the insulation film (e.g., silicon oxide film or titanium oxide film) is much easier than patterning an electrode composed of a rare metal such as platinum, etc., and the elimination part according to the design can be formed with favorable reproducibility.

Also, in the present invention, the first electrode is provided in the elimination part formed by patterning the insulation film beforehand. Therefore, it is not necessary to flatten the backing part of the dielectric capacitor as in the conventional example (FIG. 54) during the process for manufacturing the dielectric capacitor, and it is not necessary to form a side wall for insulation on the side of the first electrode. Therefore, the fabrication process count for the memory cell can be reduced further.

In the present invention, it is vital for the first electrode to have a smooth surface (in particular, smooth concave shape or convex shape). The reason is that this surface is formed by the same treatment from the surface obtained by a chemical-mechanical polishing process or etch back, etc., and differs completely from the patterning shape (the edge part of the electrode becomes an angular edge) obtained by dry etching.

In the present invention, the elimination part is the insulation film removal part provided to the insulation film according to a fine processing means such as etching, etc., and the shape is optional, such as a round shape, etc. Also, the first electrode and the second electrode refer respectively to the bottom electrode and the top electrode of the dielectric capacitor on a semiconductor substrate such as a silicon substrate (wafer), etc. The shape of these electrodes can be round or polygonal.

In the dielectric capacitor, dielectric memory device, and manufacturing method for these according to the present invention, it is preferable for at least one part of the first electrode to be embedded in the elimination part of the insulation film which was patterned beforehand, due to the aforementioned reason.

In this case, it has a structure in which the first electrode is embedded in the elimination part formed beforehand in the insulation film of silicon oxide, titanium oxide, etc. Thus, separation of the first electrodes between the memory cells becomes sufficient, along with the separation of the second electrode and the first electrode also becoming sufficient in each memory cell.

Also, in the present invention, it is preferable for the first electrode to be composed of a single layer of Pt, etc., and for the surface to be formed into a smooth concave shape or convex shape by a chemical-mechanical polishing process or etch back. However, when the surface of the first electrode is polished too much in said chemical-mechanical polishing process, the first electrode forms a smooth concave shape, and when it is polished too little, the first electrode forms a convex shape. The concave or convex shape and the degree thereof [achieved] by said chemical-mechanical polishing process can be suitably changed according to the type of abrasive material or the various parameters of the chemical-mechanical polishing device. It is also possible to process into a flat shape not created with said concave or convex shape.

When the surface of the first electrode is thus formed into a smooth concave or convex shape according to a chemical-mechanical polishing process, the surface property is favorable, so adhesion of the first electrode and the dielectric film and adherence of the second electrode become favorable, and is thus advantageous for the performance of the capacitor. Also, the surface area of the first electrode becomes larger than a completely flat surface, so the storage capacity can be increased. In particular, though the details will be discussed later, it is preferable for the first electrode to form a smooth convex shape, since the surface area of the first electrode becomes larger.

Said smooth concave or convex surface of the first electrode is not in accordance with the influence by the barrier metal layer or the backing, but is in accordance with the mandatory processing referred to as a chemical-mechanical polishing process or etch back.

Said chemical-mechanical polishing process (CMP/planarization) usable in the present invention is a processing means which uses fine particles of 1 µm or less, such as alumina (Al₂O₃) and acid or alkali, such as KOH, etc., as the abrasive material to polish the surface of the metal or oxide chemically and mechanically. CMP of metal is likened to ivory work which is a special product of damascus and is referred to as damascene. As this chemical-mechanical polishing device, for example, AVANT 1472, etc., made by Tokyo Electron Co. can be cited.

In the present invention, the first electrode formed into a prescribed shape by a chemical-mechanical polishing process differs from a first electrode formed by etching with regards to the state of the atoms at the surface, the shape of the electrode (e.g., under etching (shape defect) according to isotropic erosion in [the part] that was wet etched, adhesion of the residue at the side surface of the electrode in [the part] that was dry etched), etc. The state and shape of these can be discriminated with, for example, transmission electron microscopy (TEM).

In the present invention, it is preferable for the first electrode to be composed of a rare metal. As this electrode material, Pt is used mainly for the first electrode and the second electrode, but materials such as Ir, Pd, Ru, W, Ti, Cr, and Ni can be substituted for Pt. These metals can be used independently or in combination or mixed with other metals.

Also, in the present invention, it is preferable for the dielectric film to be composed of a high-dielectric film or ferroelectric film. The characteristics of the high-dielectric film or ferroelectric film are as noted above.

For example, the usable materials for the high-dielectric film or ferroelectric film can be PZT, PLT ((Pb,La)ₓ(Ti,Zr)₁₋ₓO₃), PTO (PbTiO₃), BTO (BaTiO₃), STO (SrTiO₃), etc., to which Nb, Zr, Fe, etc., are added in addition to the aforementioned BST and PZT.

Also, it is preferable for the insulation film to be a silicon oxide film when the dielectric film is a high-dielectric film. It is also preferable for the insulation film to be a titanium oxide film when the dielectric film is a ferroelectric film, but these insulation films can be zirconium oxide films when the ferroelectric substance is PZT. This type of insulation film (which includes titanium oxide film) has to contain the compositional elements of the dielectric film formed on it, not prevent crystallization of the dielectric substance, and not react with silicon oxide.

In particular, the PZT which is representative of the ferroelectric substance tends to generate film separation, in addition to the source material solution thereof not crystallizing on the silicon oxide film as an insulation film. Therefore, it is preferable to use titanium oxide film as the insulation film.

Furthermore, in the present invention, it is preferable for the dielectric film and the second electrode to be etched into the same pattern on the insulation film at the periphery of the first electrode. To etch into the same pattern means that the patterning frequency is reduced compared to etching into different patterns.

In the present invention, it is preferable to provide a barrier metal layer at the bottom part of the first electrode. Generally, this barrier metal is composed of Ti adhesive layer and TiN layer or TaN layer, but any conventionally known type used as a barrier metal can be used.

The present invention also provides a dielectric memory device which has said dielectric capacitor and the manufacturing method thereof, but it is preferable for the dielectric capacitor part to be provided over the bit line.

It [sic] can be a CUB structure in which the dielectric capacitor part is provided under the bit line or a structure provided over the bit line (so-called COB: Cell Over Bit line), but there are the following merits when it is the COB structure.

First, the dielectric film and the second electrode are positioned on the surface layer side of the dielectric memory device, so insulation between these and the bit line contact can be executed easily, the dielectric film and the second electrode can be formed with a margin, and the patterning thereof can be executed by wet etching. Therefore, dry etching need not be used in the patterning of the dielectric film, and wet etching by an acid such as aqua regia, etc., can be used.

Second, the dielectric capacitor can be fabricated in the final process of the dielectric memory cell manufacture, so processes applied with heat and pressure in the processes thereafter are minimal. Thus, the degradation in the physical property of the dielectric film can be lessened.

Third, the plate electrode (second electrode) which is grounded is positioned on the front layer side, so the internal potential stabilizes in accordance.

### BRIEF DESCRIPTION OF THE DRAWINGS

FIG. 1 is a sectional figure (sectional figure along line I-I in FIG. 1) of a high-dielectric memory cell which integrates the high-dielectric capacitor according to the first embodiment of the present invention.

FIG. 2 is top view of the memory cell in the first embodiment of the present invention.

FIG. 3 is a sectional figure showing a processing step in the manufacturing method for a memory cell according to the first embodiment of the present invention.

FIG. 4 is a sectional figure showing another processing step in the manufacturing method for a memory cell according to the first embodiment of the present invention.

FIG. 5 is a sectional figure showing another processing step in the manufacturing method for a memory cell according to the first embodiment of the present invention.

FIG. 6 is a sectional figure showing another processing step in the manufacturing method for a memory cell according to the first embodiment of the present invention.

FIG. 7 is a sectional figure showing another processing step in the manufacturing method for a memory cell according to the first embodiment of the present invention.

FIG. 8 is a sectional figure showing another processing step in the manufacturing method for a memory cell according to the first embodiment of the present invention.

FIG. 9 is a sectional figure showing another processing step in the manufacturing method for a memory cell according to the first embodiment of the present invention.

FIG. 10 is a sectional figure showing another processing step in the manufacturing method for a memory cell according to the first embodiment of the present invention.

FIG. 11 is a sectional figure showing another processing step in the manufacturing method for a memory cell according to the first embodiment of the present invention.

FIG. 12 is a sectional figure showing another processing step in the manufacturing method for a memory cell according to the first embodiment of the present invention.

FIG. 13 is a sectional figure showing another processing step in the manufacturing method for a memory cell according to the first embodiment of the present invention.

FIG. 14 is a sectional figure showing another processing step in the manufacturing method for a memory cell according to the first embodiment of the present invention.

FIG. 15 is a sectional figure showing another processing step in the manufacturing method for a memory cell according to the first embodiment of the present invention.

FIG. 16 is a sectional figure showing another processing step in the manufacturing method for a memory cell according to the first embodiment of the present invention.

FIG. 17 is a sectional figure showing another processing step in the manufacturing method for a memory cell according to the first embodiment of the present invention.

FIG. 18 is a sectional figure showing another processing step in the manufacturing method for a memory cell according to the first embodiment of the present invention.

FIG. 19 is a sectional figure showing another processing step in the manufacturing method for a memory cell according to the first embodiment of the present invention.

FIG. 20 is a sectional figure of a high-dielectric memory cell which integrates a high-dielectric capacitor according to the second embodiment of the present invention.

FIG. 21 is a sectional figure showing a processing step in the manufacturing method for a memory cell according to the second embodiment of the present invention.

FIG. 22 is a sectional figure showing another processing step in the manufacturing method for a memory cell according to the second embodiment of the present invention.

FIG. 23 is a sectional figure showing another processing step in the manufacturing method for a memory cell according to the second embodiment of the present invention.

FIG. 24 is a sectional figure showing another processing step in the manufacturing method for a memory cell according to the second embodiment of the present invention.

FIG. 25 is a sectional figure of a ferroelectric memory cell which integrates a ferroelectric capacitor according to the third embodiment of the present invention.

FIG. 26 is a sectional figure showing a processing step in the manufacturing method for a memory cell according to the third embodiment of the present invention.

FIG. 27 is a sectional figure showing another processing step in the manufacturing method for a memory cell according to the third embodiment of the present invention.

FIG. 28 is a sectional figure showing another processing step in the manufacturing method for a memory cell according to the third embodiment of the present invention.

FIG. 29 is a sectional figure showing another processing step in the manufacturing method for a memory cell according to the third embodiment of the present invention.

FIG. 30 is a sectional figure showing another processing step in the manufacturing method for a memory cell according to the third embodiment of the present invention.

FIG. 31 is a sectional figure showing another processing step in the manufacturing method for a memory cell according to the third embodiment of the present invention.

FIG. 32 is a sectional figure showing another processing step in the manufacturing method for a memory cell according to the third embodiment of the present invention.

FIG. 33 is a sectional figure showing another processing step in the manufacturing method for a memory cell according to the third embodiment of the present invention.

FIG. 34 is a sectional figure (sectional FIG. along line XXXIV-XXXIV in FIG. 35) of a high-dielectric memory cell which integrates a high-dielectric capacitor according to the fourth embodiment of the present invention.

FIG. 35 is a top view of a memory cell according to the fourth embodiment of the present invention.

FIG. 36 is a sectional figure showing a processing step in the manufacturing method for a memory cell according to the fourth embodiment of the present invention.

FIG. 37 is a sectional figure showing another processing step in the manufacturing method for a memory cell according to the fourth embodiment of the present invention.

FIG. 38 is a sectional figure showing another processing step in the manufacturing method for a memory cell according to the fourth embodiment of the present invention.

FIG. 39 is a sectional figure showing another processing step in the manufacturing method for a memory cell according to the fourth embodiment of the present invention.

FIG. 40 is a sectional figure showing another processing step in the manufacturing method for a memory cell according to the fourth embodiment of the present invention.

FIG. 41 is a sectional figure showing another processing step in the manufacturing method for a memory cell according to the fourth embodiment of the present invention.

FIG. 42 is a sectional figure showing another processing step in the manufacturing method for a memory cell according to the fourth embodiment of the present invention.

FIG. 43 is a sectional figure showing another processing step in the manufacturing method for a memory cell according to the fourth embodiment of the present invention.

FIG. 44 is a sectional figure showing another processing step in the manufacturing method for a memory cell according to the fourth embodiment of the present invention.

FIG. 45 is a sectional figure showing another processing step in the manufacturing method for a memory cell according to the fourth embodiment of the present invention. FIG. 46 is a sectional figure showing another processing step in the manufacturing method for a memory cell according to the fourth embodiment of the present invention.

FIG. 47 is a sectional figure showing another processing step in the manufacturing method for a memory cell according to the fourth embodiment of the present invention.

FIG. 48 is a sectional figure showing another processing step in the manufacturing method for a memory cell according to the fourth embodiment of the present invention.

FIG. 49 is a sectional figure showing another processing step in the manufacturing method for a memory cell according to the fourth embodiment of the present invention.

FIG. 50 is a sectional figure of a high-dielectric memory cell which integrates a high-dielectric capacitor according to a conventional example.

FIG. 51 is a sectional figure showing a processing step in the manufacturing method for a memory cell according to a conventional example.

FIG. 52 is a sectional figure showing another processing step in the manufacturing method for a memory cell according to a conventional example.

FIG. 53 is a sectional figure showing another processing step in the manufacturing method for a memory cell according to a conventional example.

FIG. 54 is a sectional figure showing another processing step in the manufacturing method for a memory cell according to a conventional example.

FIG. 55 is a sectional figure showing another processing step in the manufacturing method for a memory cell according to a conventional example.

FIG. 56 is a sectional figure showing another processing step in the manufacturing method for a memory cell according to a conventional example.

FIG. 57 is a sectional figure showing another processing step in the manufacturing method for a memory cell according to a conventional example.

FIG. 58 is a sectional figure showing another processing step in the manufacturing method for a memory cell according to a conventional example.

FIG. 59 is a sectional figure showing another processing step in the manufacturing method for a memory cell according to a conventional example.

FIG. 60 is a sectional figure showing another processing step in the manufacturing method for a memory cell according to a conventional example.

FIG. 61 is a sectional figure showing another processing step in the manufacturing method for a memory cell according to a conventional example.

FIG. 62 is a sectional figure showing another processing step in the manufacturing method for a memory cell according to a conventional example.

FIG. 63 is a sectional figure showing another processing step in the manufacturing method for a memory cell according to a conventional example.

FIG. 64 is a sectional figure showing another processing step in the manufacturing method for a memory cell according to a conventional example.

### REFERENCE NUMERALS AND SYMBOLS AS SHOWN IN THE DRAWINGS

1 Silicon substrate, 3 N⁺-type drain region, 4 N⁺-type source region, 6 (WL) word line, 7, 21, 47 silicon oxide films, 8 polysilicon layer, 29, 38 bottom electrodes, 20, 40 high-dielectric films, 34 ferroelectric film, 33 oxidized titanium film (titanium oxide film), 31 photoresist, 23, 37 top electrodes, 24 (BL) bit line, 29a concave surface, 29b convex surface, GAP(1), CAP(2), CAP(3), CAP(4), Cap dielectric capacitors, M-CEL(1), M-CEL(2), M-CEL(3), M-CEL(4), M-cel memory cells, TR transfer gate.

### DESCRIPTION OF EMBODIMENTS

Below, the present invention will be explained with regard to embodiments.

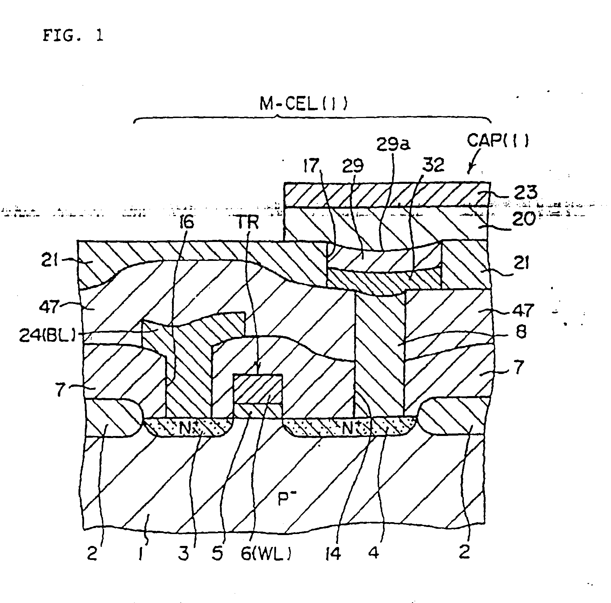

FIGS. 1-19 show the first embodiment, which applies the present invention to a high-dielectric capacitor and a memory device thereof.

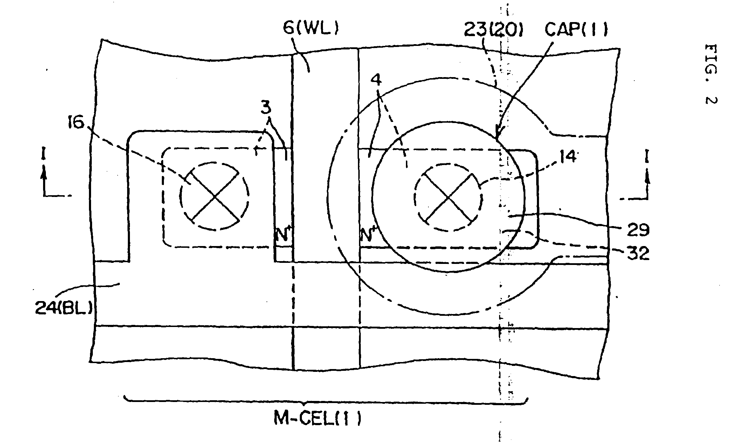

First, the high-dielectric capacitor and high-dielectric memory device with a COB (Cell Over Bit line) structure which integrated the above according to this embodiment will be explained with regards to FIGS. 1 and 2.

High dielectric capacitor CAP(1) according to this embodiment is comprised of platinum (Pt) layer 29 as the bottom electrode embedded in elimination part 17 of insulation layer 21, high-dielectric film 20 composed of BST ((Ba,Sr)TiO₃) adhered on it, and platinum (Pt) layer 23 provided on it as the top electrode in the same pattern as high-dielectric film 20.

Here, it is important for through-hole 17 to be formed into a prescribed size and shape (approximately a round shape in this embodiment) as the elimination part by patterning with etching beforehand in insulation film 21 composed of SiO₂, and for bottom electrode 29 adhered so as to be embedded in said through-hole 17 to be formed into a prescribed shape according to a chemical-mechanical polishing process (CMP). Then, by bottom electrode 24 being a single layer and the chemical-mechanical polishing process being executed excessively, the surface is provided with smooth (gentle) concave surface 29a.

To the bottom layer of bottom electrode 29, barrier metal layer 32 composed of a TiN and Ti adhesive layer is provided and is connected to the silicon substrate side via polysilicon layer (plug) 8 which is adhered so as to be embedded into contact hole (14) of SiO₂ insulation layers 7 and 47. The top surface of polysilicon layer 8 forms a somewhat concave shape by etch back to be discussed later, and following this shape, even the top surface of barrier metal layer 32 assumes a somewhat concave shape by etch back to be discussed later.

Bottom electrode 29 and top electrode 23 can be formed into a film thickness of 50-300 nm (e.g., 100 nm) according to the electron-beam-heating vacuum vapor deposition method.

Also, high-dielectric film 20 composed of BST is formed into a thickness of 20-30 nm (e.g., 30 nm) according to vapor deposition on bottom electrode 29. This high-dielectric film 20 can be formed with composition of Ba:Sr:Ti = X:(1-X):1 (however, 0 ≤ X < 0.8, for example, 0.5:0.5:1).

In memory cell M-CEL(1) of a DRAM having said high-dielectric capacitor CAP(1), element region partitioned by field oxide film 2 is formed on one principal surface of, for example, P⁺-type silicon substrate 1. Here, memory cell M-CEL(1) composed of capacitor CAP(1) and transfer gate (TR) composed of a MOS transistor are provided.

In transfer gate (TR), for example, N⁺-type drain region 3 and N⁺-type source region 4 are formed by impurity diffusion, word line 6 (WL) is provided between these regions via gate oxide film 5, and bit line 24 (BL) is connected to drain region 3 via insulation layer 7 of SiO₂, etc., and contact hole 16. The top of this bit line is covered with insulation film 47 of SiO₂, etc.

High dielectric capacitor CAP(1) according to this embodiment is provided to be over bit line 24 (BL) and is a COB type of high-dielectric memory device which has the afdrementioned features.

Next, fabrication of high-dielectric capacitor CAP(1) and memory cell M-CEL(1) in this embodiment will be explained with regards to FIGS. 3-19.

First, as shown in FIG. 3, field oxide film 2 is formed on P⁻-type silicon substrate (wafer) 1 by selective oxidation, gate oxide film 5 is formed by thermal oxidation, polysilicon word line 6 (WL) is formed by chemical vapor deposition (so-called CVD), and N⁺-type drain region 3 and source region 4 are formed by thermal diffusion of N-type impurities such as As, etc.

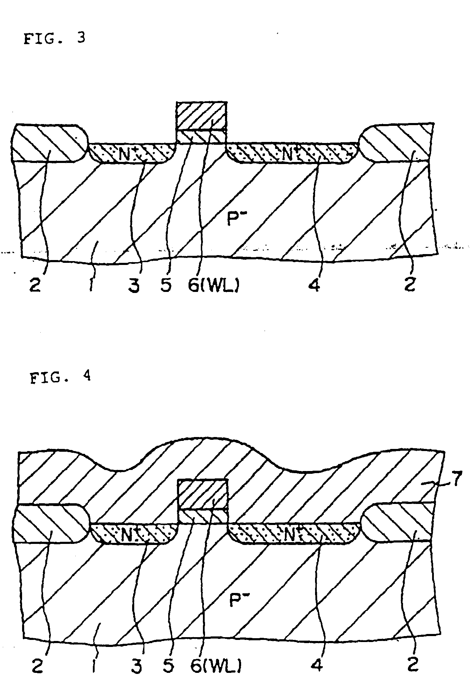

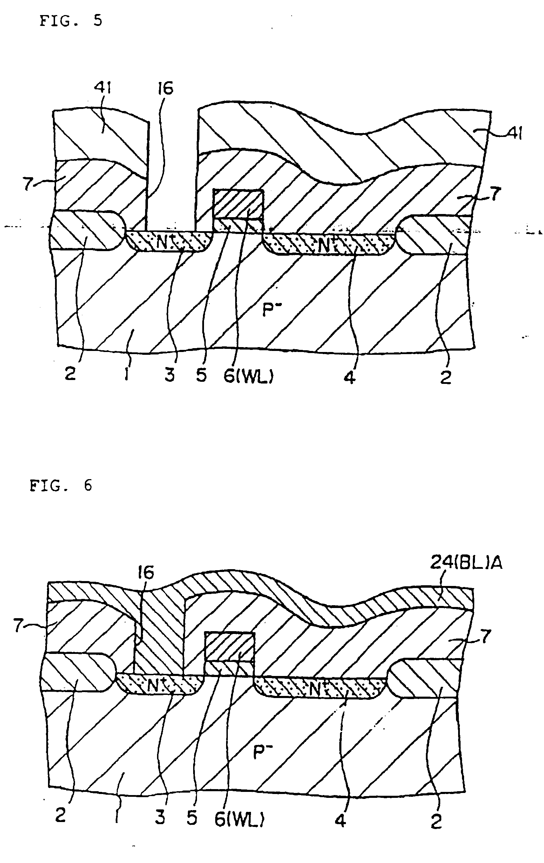

Next, SiO₂ insulation layer 7 is deposited on the entire surface by the chemical vapor deposition method, as shown in FIG. 4. With respect to this SiO₂ insulation layer 7, contact hole 16 is formed by photolithography on drain region 3 with photoresist 41, which was patterned as a mask as shown in FIG. 5.

Next, as shown in FIG. 6, polysilicon 24A which is the material for the bit line is adhered on SiO₂ insulation layer 7 so as to be embedded in contact hole 16. At this time, it is not necessary in particular to surface treat SiO₂ insulation layer 7, but flattening can be applied if a large gradation has formed.

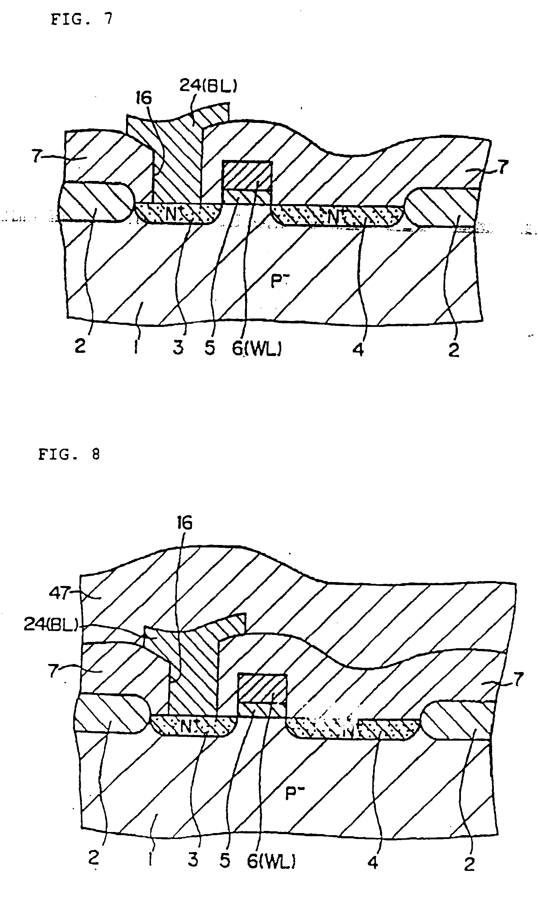

Next, as shown in FIG. 7, bit line 24 is formed into a prescribed shape by etching. This formed bit line 24 takes on a shape associated with the surface shape of SiO₂ insulation layer 7.

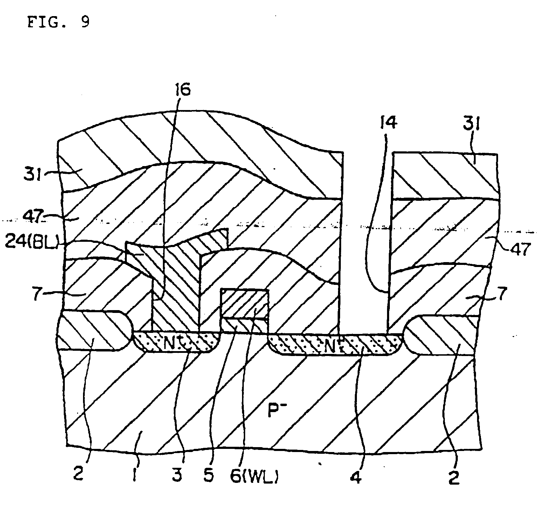

Next, as shown in FIG. 8, SiO₂ insulation layer 47 is deposited on the entire surface by chemical vapor deposition.

Next, as shown in FIG. 9, with respect to SiO₂ insulation layers 7 and 47, contact hole 14 is formed on source region 4 with photoresist 31 which was patterned as a mask. Patterning of the SiO₂ insulation layer by said photolithography is executed by plasma etching which uses fluorocarbons such as CF₄, C₂F₈, etc., as the etchant.

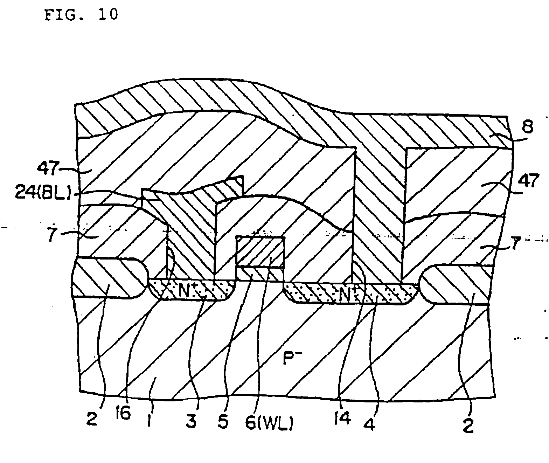

Next, as shown in FIG. 10, polysilicon layer 8 is adhered so as to be embedded in contact hole 14 by contacting source region 4 by chemical vapor deposition.

Next, as shown in FIG. 11, polysilicon layer 8 is etched back and embedded so as to be left as a storage node in contact hole 14. Polysilicon layer 8 just needs to be left within contact hole 14 by this etch back; it is not necessary to flatten the surface.

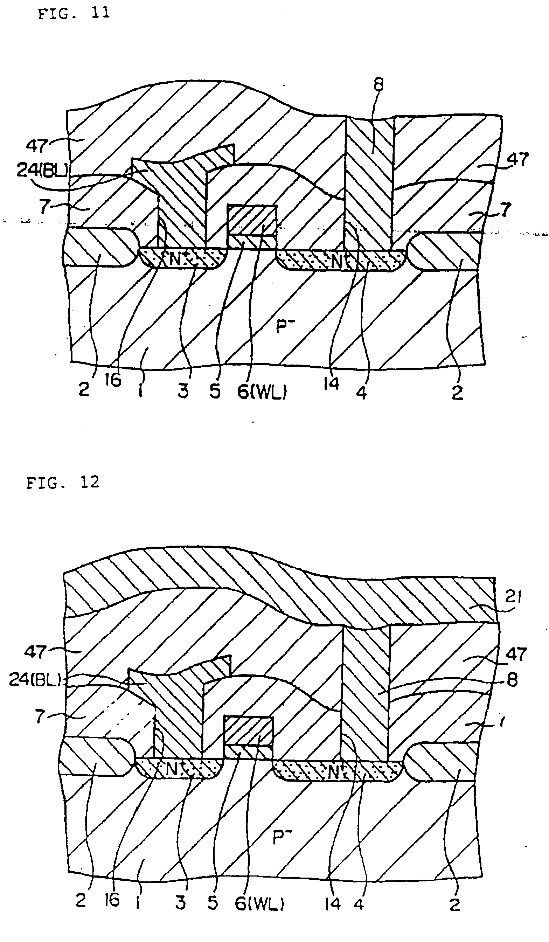

Next, it is important from here that SiO₂ insulation layer 21 is adhered to the entire surface by chemical vapor deposition as shown in FIG. 12. Namely, instead of forming a barrier metal and first electrode (bottom electrode) as in the conventional method, insulation layer 21 which determines the thickness and the pattern of the bottom electrode is formed. The thickness of insulation layer 21 can be 3000-8000 Å, for example, about 5000 Å.

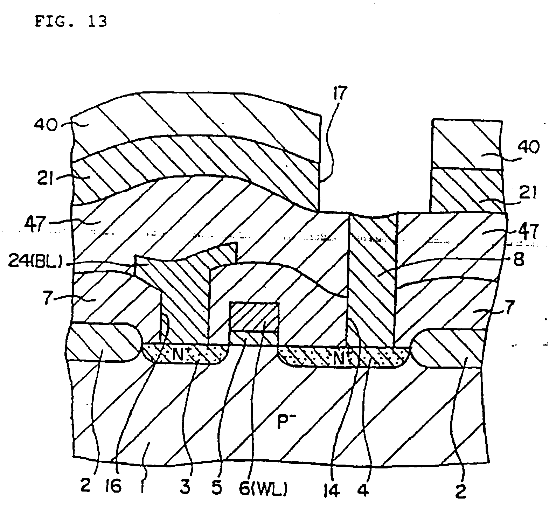

Next, as shown in FIG. 13, insulation layer 21 is etched according to photolithography with photoresist 4 as a mask and through-hole 17 as the elimination part is formed into a prescribed pattern. Patterning of insulation layer 21 by said photolithography is executed with plasma etching which uses fluorocarbons such as CF₄, C₂F₆, etc., as the etchant. This through-hole 17 can be formed into a planar size of 0.5 µm or less.

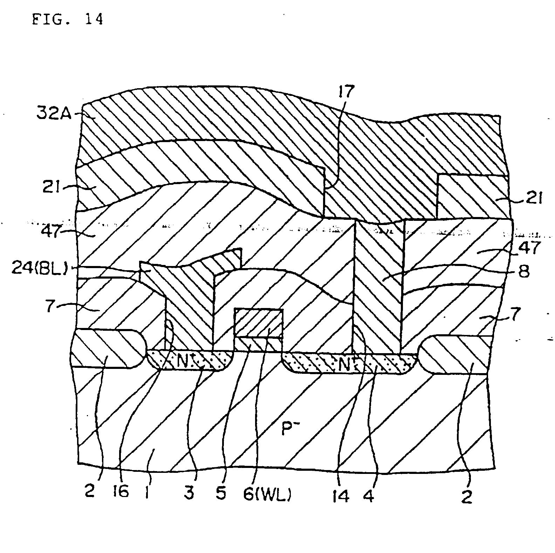

Next, as shown in FIG. 14, a material for barrier metal layer 32A composed of a TiN layer and Ti adhesive layer is adhered to the entire surface by a physical deposition method such as vacuum vapor deposition.

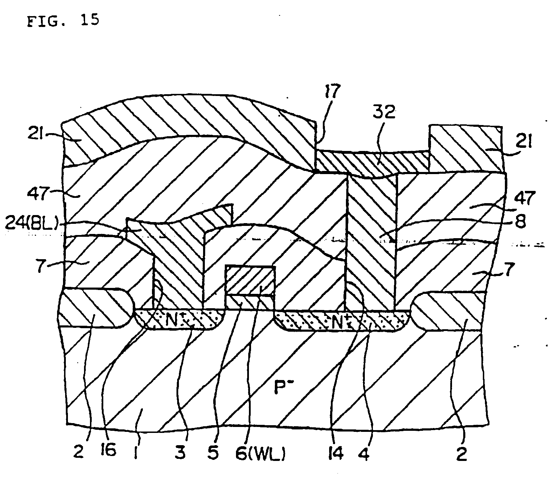

Next, as shown in FIG. 15, barrier metal layer 32 is formed selectively in through-hole 17 of insulation layer 21 by etch back to be the shape of this through-hole.

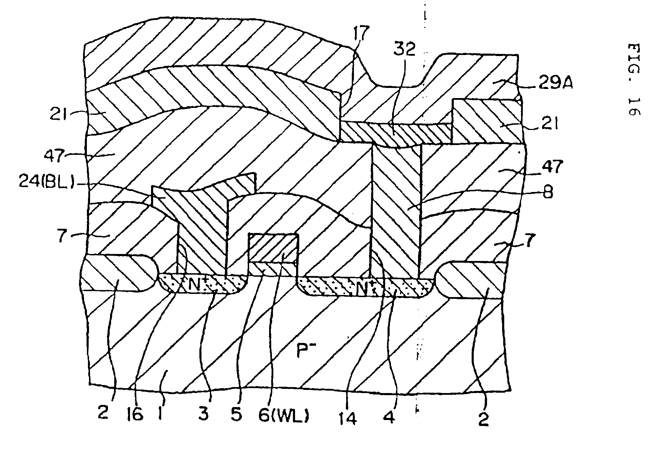

Next, as shown in FIG. 16, bottom electrode material layer 29A composed of a Pt layer is formed on the entire surface by a physical deposition method such as vacuum vapor deposition.

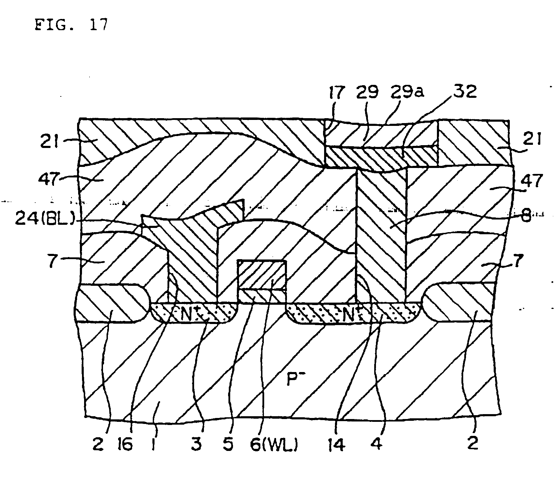

Next, as shown in FIG. 17, the surface of electrode material layer 29A is polished uniformly by said chemical-mechanical polishing process (CMP), and bottom electrode 29 is formed so as to be embedded in through-hole 17 of insulation layer 21. At this time, polishing by a chemical-mechanical polishing process is executed slightly more, and bottom electrode 29 is formed into the same shape (or pattern) as through-hole 17 so that the surface shape of bottom electrode 29 becomes a smooth concave surface 29a. This bottom electrode 29 can be formed into thickness of about 100 nm.

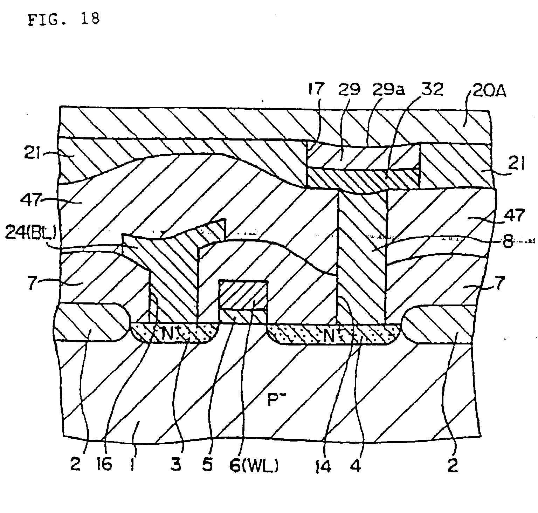

Next, as shown in FIG. 18, high-dielectric film material 20A composed of BST is adhered in a thickness of, for example, about 300 Å by sputtering. The adhesive property thereof is favorable even if there are irregularities in the backing and is improved even more by concave surface 29a of bottom electrode (29).

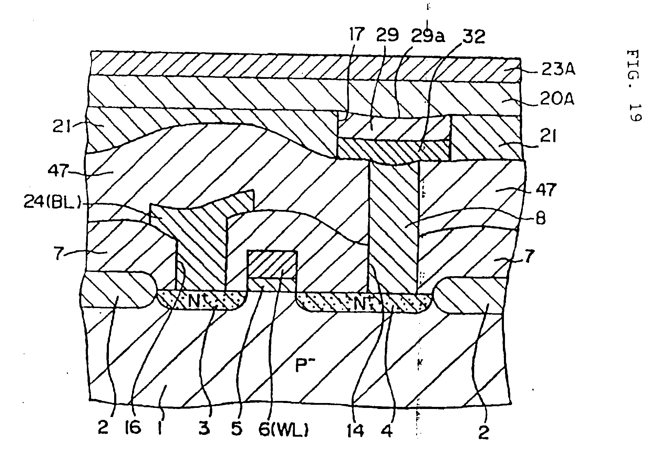

Next, as shown in FIG. 19, Pt layer (23A) for the top electrode is adhered by a physical deposition method such as vacuum vapor deposition.

Next, top electrode material layer (23A) and high-dielectric film material 20A are superimposed on approximately the same pattern and wet etched with a common mask (photoresist: not shown in the figure), top electrode 23 and high-dielectric film 20 of same pattern are formed, and memory cell M-CEL(1) having a high-dielectric capacitor CAP(1) as shown in FIG. 1 is fabricated.

As explained above, according to this embodiment, elimination part 17 is patterned beforehand in insulation film 21. Thus, by treating electrode material 29A adhered to this elimination part with a chemical-mechanical polishing process, bottom electrode 29 of a prescribed shape can be obtained even if bottom electrode 29 is not patterned by etching. Therefore, even if the bottom electrode is composed of Pt, it is not necessary to wet etch or dry etch this as in the conventional technology, so residue is not created during the etching and a high integration is achieved by making the electrode size small. Also, bottom electrode 29 is surrounded by insulation film 21 so top electrode 23 and high-dielectric film 20 can be separated favorably between the cells. Favorable separation is possible even between top electrode 23 and bottom electrode 29, thus; it is possible to obtain dielectric capacitor CAP(1) and memory cell M-CEL(1) in which current leakage is minimal and the insulation property is favorable. Also, top electrode 23 can be processed into a prescribed shape with a margin according to wet etching.

Also, according to this embodiment, by forming elimination part 17 of insulation film 21 into the electrode shape beforehand, bottom electrode 29 can be formed into a prescribed shape just by treating the bottom electrode material from the surface. Thus, patterning by etching becomes unnecessary, and [the number of] processes for patterning the electrode in which etching is difficult can be reduced by one, so economical and highly efficient manufacture is possible, including reducing the cost, manufacturing time, etc.

Patterning of the insulation film (e.g., silicon oxide film or titanium oxide film) is much easier than patterning of an electrode composed of a rare metal such as platinum, etc., and elimination part 17 (which is in particular as fine as 0.5 µm or less) according to the design can be formed with favorable reproducibility.

Also, bottom electrode 29 is provided to elimination part 17 which was formed with insulation film 21 beforehand by patterning. Therefore, it is not necessary to flatten the bottom part of the dielectric capacitor in the process for manufacturing the dielectric capacitor as in the conventional example (FIG. 54), and it is not necessary to form a side wall for insulation on the side surface of bottom electrode 29. Therefore, it is possible to further reduce the fabrication process count for the memory cell.

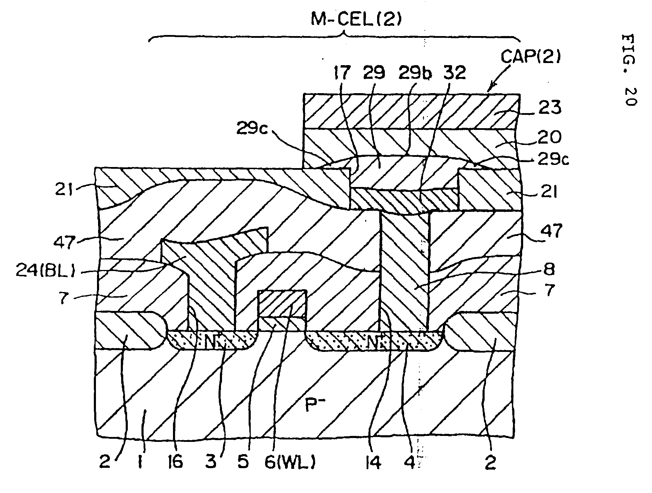

FIGS. 20-24 show the second embodiment which applies the present invention to a high-dielectric capacitor and a memory device thereof.

High-dielectric capacitor CAP(2) according to this embodiment is comprised of platinum (Pt) layer 29 as the bottom electrode embedded in elimination part 17 of insulation layer 21, high-dielectric film 20 composed of BST ((Ba,Sr)TiO₃ film) adhered to it, and platinum (Pt) layer 23 provided on it to be the same pattern as high-dielectric film 20 as the top electrode as the aforementioned first embodiment shown in FIG. 20. However, when compared with said first embodiment, it differs in that the surface of bottom electrode 29 has a smooth (gentle) convex surface 29b, and one part 29c thereof slightly protrudes above insulation film 21.

Namely, through-hole 17 as the elimination part is formed beforehand into a prescribed size and prescribed shape by patterning according to etching in insulation film 21 composed of SiO₂. Bottom electrode 29 adhered to said through-hole 17 is a single layer and is formed into a prescribed shape by a chemical-mechanical polishing process (CMP), and the surface has smooth convex surface 29b by executing less of said chemical-mechanical polishing process.

Bottom electrode 29 of high-dielectric capacitor CAP(2) according to this embodiment has smooth convex surface 29b, and one part 29c thereof protrudes above insulation film 21. Thus, the electrode area is larger than bottom electrode 29 in the aforementioned first embodiment, and the charge storage capacity becomes large, as for a capacitor. Other than the surface shape of bottom electrode 29, it has the same constitution as the aforementioned first embodiment, so the aforementioned effects can be similarly obtained.

Also, high-dielectric capacitor CAP(2) of this embodiment is provided over bit line 24 (BL) and has the aforementioned merits of a COB-type high-dielectric memory device.

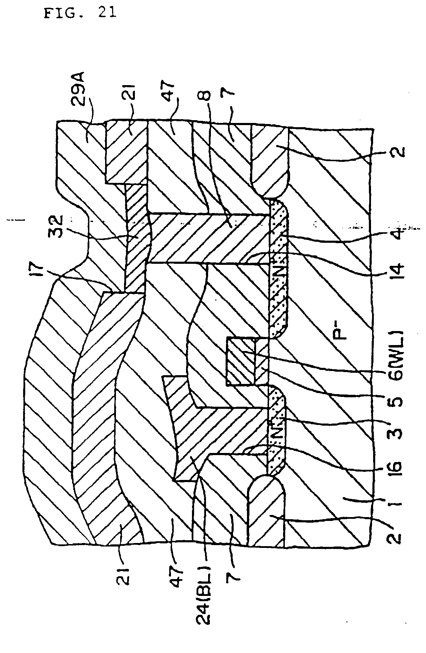

Next, the main steps in the fabrication process for high-dielectric capacitor CAP(2) and memory cell (M-CEL)2)) according to this embodiment will be explained with regards to FIGS. 21-24. However, the processes up to FIG. 21 are the same as the processes in FIGS. 3-16 for the aforementioned first embodiment, so the figures and explanation will be omitted.

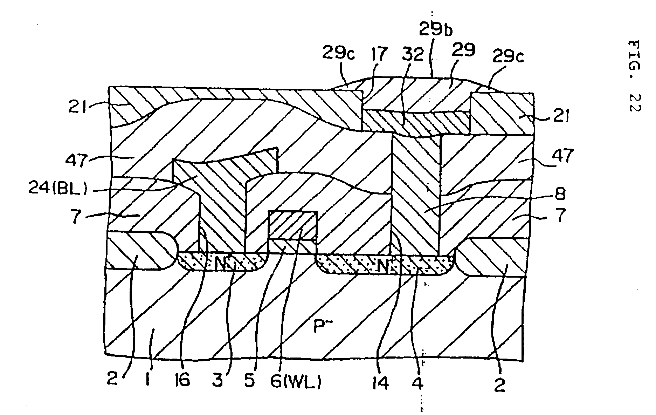

After forming Pt layer 29A, which is the bottom electrode material on the entire surface, by vacuum vapor deposition, etc., by chemical-mechanical polishing (CMP) bottom electrode material layer 29A as shown in FIG. 21, bottom electrode (29) is formed into a prescribed pattern of being embedded in through-hole 17 formed beforehand in insulation layer 21 as shown in FIG. 22. At this time, polishing according to a chemical-mechanical polishing process is slightly less, so that the shape of bottom electrode 29 has smooth convex surface 29b, and one part 29c thereof protrudes above insulation layer 21. This bottom electrode 29 can be formed for the thickness to be about 100 nm.

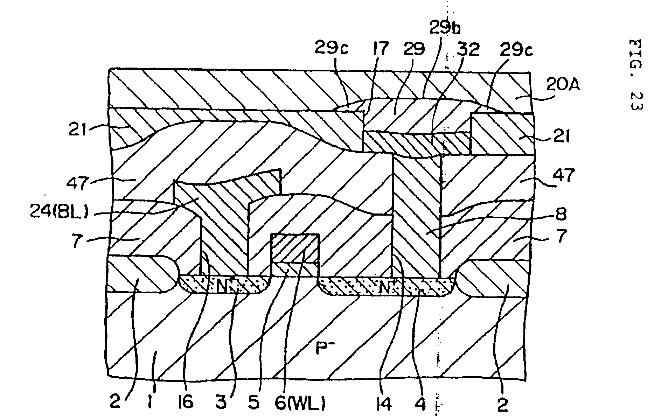

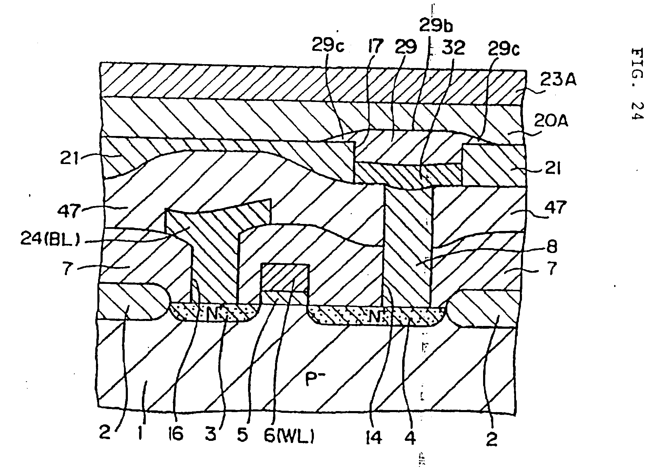

Next, high-dielectric film material 20A composed of BST is adhered according to sputtering as shown in FIG. 23, and Pt layer 23A for the top electrode is adhered to it by vacuum vapor deposition, etc., as shown in FIG. 24.

Next, top electrode material layer 23A and high-dielectric film material layer 20A are superimposed to approximately the same pattern and etched, top electrode 23 and high-dielectric film 20 of the same pattern are formed, and memory cell M-CEL(2) as shown in FIG. 20 is fabricated.

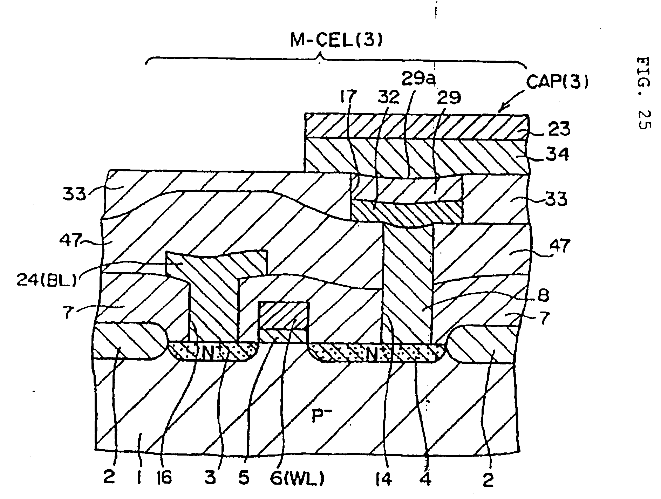

FIGS. 25-33 show the third embodiment, which applies the present invention to a ferroelectric capacitor.

In each of the embodiments discussed above, a high-dielectric memory device integrated with a high-dielectric capacitor which uses BST was explained. However, in this embodiment, a ferroelectric memory device which integrated a ferroelectric capacitor is targeted.

Ferroelectric capacitor CAP(3) of this embodiment is comprised of platinum (Pt) layer 29 as the bottom electrode, ferroelectric film 34 composed of PZT (Pb(Zr,Ti)O₃) formed on it according to the sol-gel method, and platinum (Pt) layer 23 provided on it in same pattern as ferroelectric film 34 as the top electrode, as shown in FIG. 25.

In this embodiment, with regards to the bottom electrode, it is the same as the aforementioned first embodiment in the fact that bottom electrode 29 is treated with a chemical-mechanical polishing process (CMP) to embed in through-hole 17 of insulation film 33, the surface thereof has concave surface 29a, and that the aforementioned effects can be obtained. However, it differs in the fact that titanium oxide (TiO₂) is used in particular as insulation layer 33. When insulation layer 33 is SiO₂, oxidation (PbO₂) occurs in the Pb within PZT according to SiO₂ in the contact part of the SiO₂ insulation layer and the ferroelectric film of PZT(Pb(Zr,Ti)O₃ film). Thus, PZT does not crystallize sufficiently, and film separation is generated in said contact part. When TiO₂ film is used as insulation layer 33, reaction with PZT is not generated, so said phenomenon can be sufficiently prevented. Also, ferroelectric film 34 composed of PZT (Pb(Zr,Ti)O₃ film) can be formed by sputtering or CVD, in addition to the sol-gel method.

According to the sol-gel method, the sol-gel source material for the ferroelectric substrate of PZT becomes a dried gel film by heating and drying for, for example, 3 min at 100-300°C (e.g., 170°C) and is made amorphous by heat treating (at about 480°C) further. Furthermore, PZT thin film which was made amorphous is annealed (sintered) for 10 min at over 600°C in the atmosphere or in an oxygen-containing atmosphere [sic], and becomes a PZT ferroelectric thin film with a perovskite structure.

The source material (PZT precursor) in the sol-gel method can be a CH₃OC₂H₄OH solution of Pb(CH₃COO)₂·3H₂O, Ti{(CH₃)₂ CHO}₄, Zr{CH₃(CH₂)₂CH₂O}₄, and NH(CH₂CH₂OH)₂, and this is coated and dried. The composition of this source material solution (or amorphous thin film) can have an excess of Pb and the ratio in the number of atoms can be Pb:Zr:Ti = 1.1:0.5:0.5.

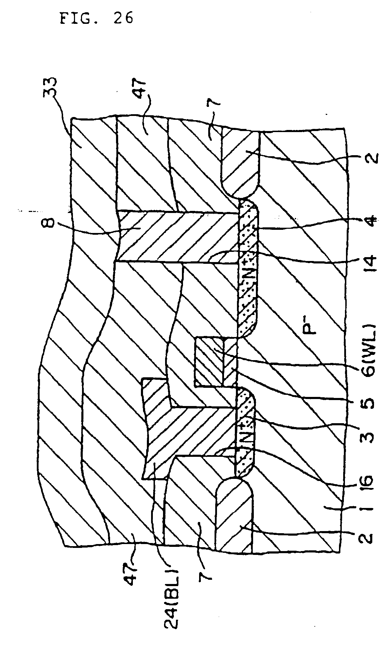

Next, a fabrication process for high-dielectric capacitor CAP(3) and memory cell M-CEL(3) in this embodiment will be explained with regards to FIGS. 26-33. However, processes up to FIG. 26 are the same as the processes in FIGS. 3-11 in the aforementioned first embodiment, so figures and explanatipn will be omitted.

In FIG. 12 of the aforementioned first embodiment, a silicon oxide film is adhered as insulation film 21. However, in this embodiment, a titanium oxide film is adhered as insulation film 33 by chemical vapor deposition, as shown in FIG. 26.

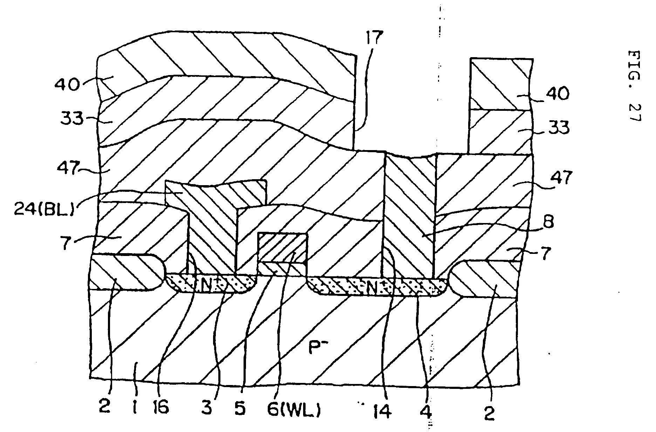

Next, insulation layer 33 is etched with photoresist 40 as a mask according to photolithography, and through-hole 17 is formed as shown in FIG. 27.

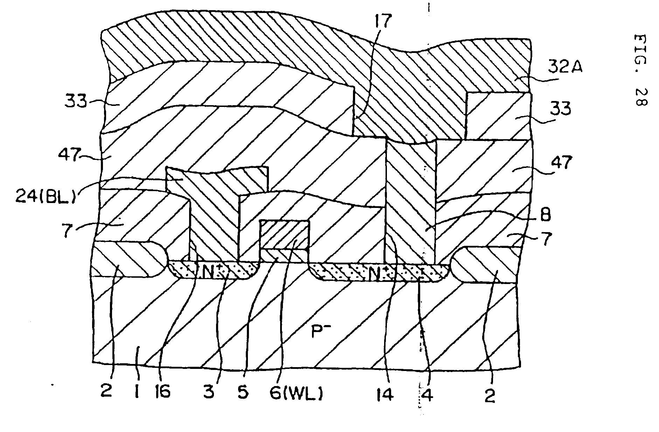

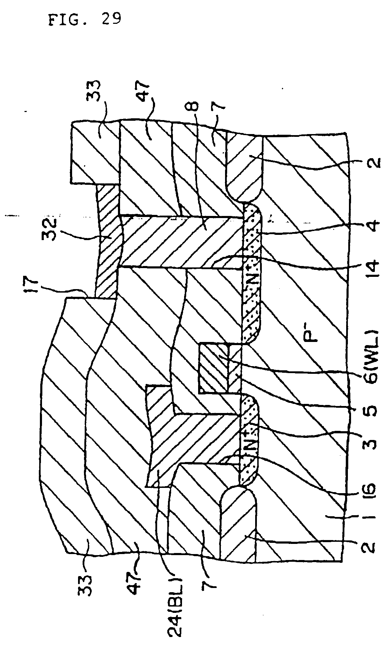

Next, after adhering a material for barrier metal layer 32A composed of a TiN layer and Ti adhesive layer on the entire surface by vacuum vapor deposition, etc., as shown in FIG. 28, barrier metal layer 32 is left in elimination part 17 of insulation layer 33 by etch back as shown in FIG. 29.

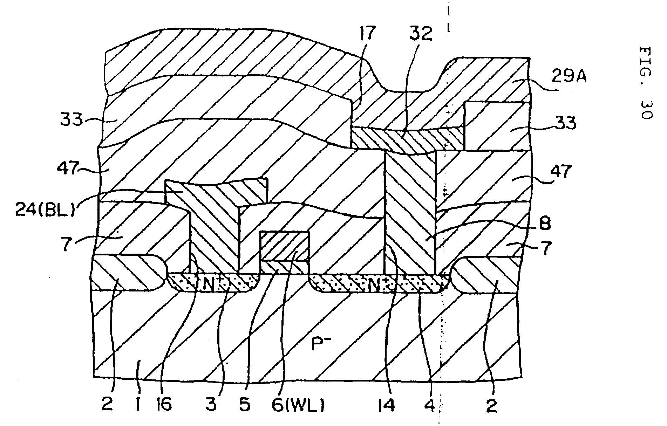

Next, bottom electrode material layer 29A composed of a Pt layer is formed on the entire surface by vacuum vapor deposition, etc., as shown in FIG. 30.

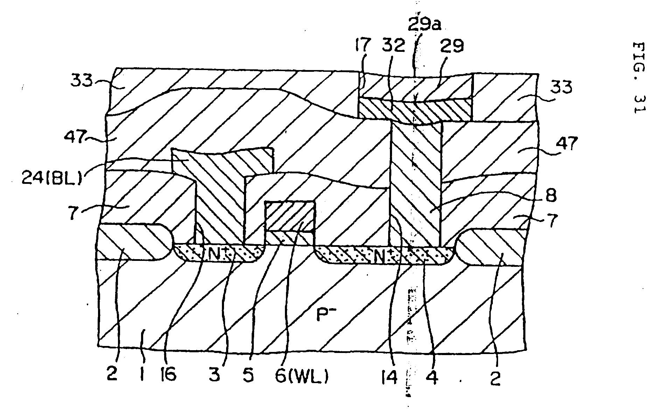

Next, by chemical-mechanical polishing (CMP) of bottom electrode material layer 29A, bottom electrode 29 is formed into a prescribed pattern so as to take a form of being embedded in elimination part 17 of insulation layer 33, as shown in FIG. 31. At this time, polishing according to a chemical-mechanical polishing process is executed slightly more, so that the shape of the first electrode becomes smooth concave surface 29a. This bottom electrode 29 is formed into a thickness of about 100 nm.

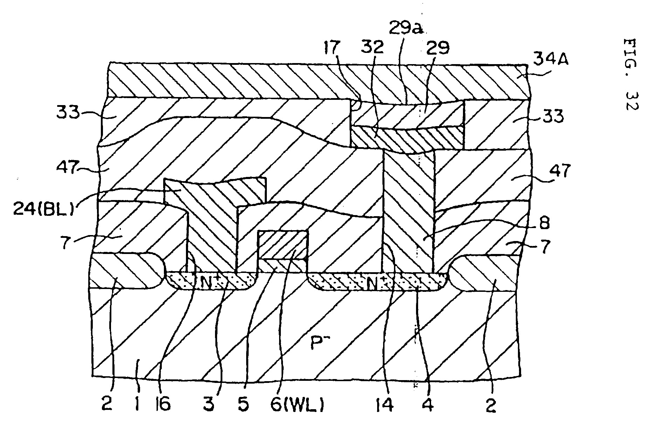

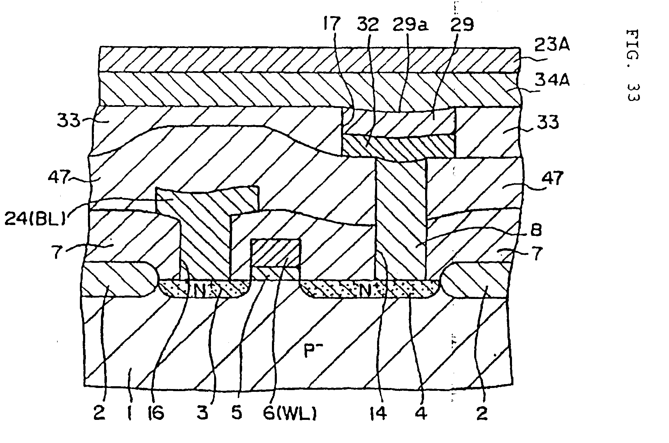

Next, ferroelectric film material 34A composed of PZT is adhered according to the sol-gel method, as shown in FIG. 32. On this, Pt layer 23 for the top electrode is formed by vacuum vapor deposition, etc., as shown in FIG. 33.

Next, top electrode material layer 23 and ferroelectric film material 34A are superimposed on approximately the same pattern and etched, top electrode 23 and PZT ferroelectric film material 34 of the same pattern are formed, and memory cell M-CEL(3) which has ferroelectric capacitor CAP(3) shown in FIG. 25 is fabricated.

In this embodiment, PZT ferroelectric film (34) is formed without contacting the silicon oxide film, *so* the PZT ferroeiectric film is sufficiently crystallized.

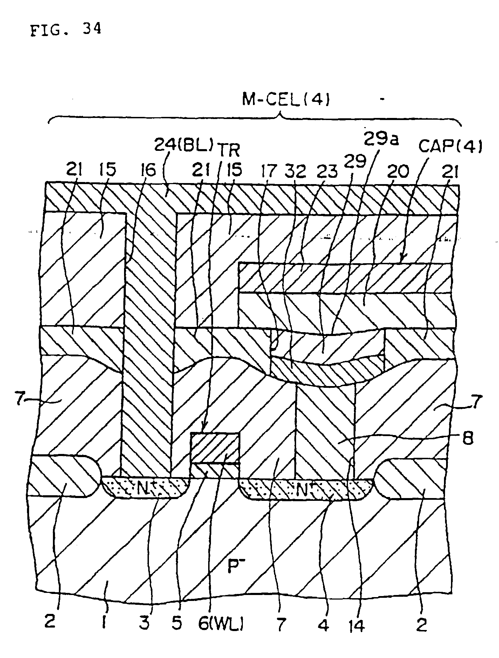

FIGS. 34-39 show the fourth embodiment, which applies the present invention to a high-dielectric capacitor with a CUB structure and a memory device thereof.

Next, the fourth embodiment will be explained.

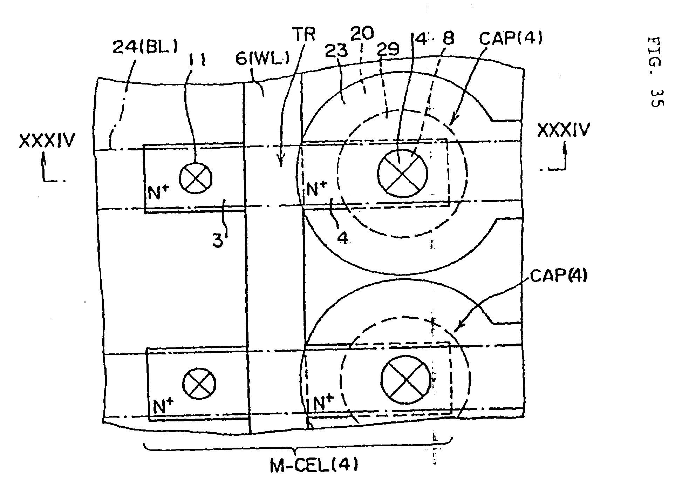

First, high-dielectric capacitor CAP(4) according to this embodiment and high-dielectric memory cell M-CEL(4j which integrated this will be explained with regard to FIGS. 34 and 35.

In memory cell M-CEL(4) according to this embodiment, other than the fact that it is the so-called CUB type in which high-dielectric capacitor CAP(4) is installed to be under bit line 24 (BL), it is composed basically with the same constitution as the aforementioned first embodiment.

A fabrication process for high-dielectric capacitor CAP(4) and memory cell M-CEL(4) in this embodiment will be explained with regard to FIGS. 36-49.

First, after the process in FIG. 3 of said first embodiment, SiO₂ insulation layer 7 is deposited on the entire surface by chemical vapor deposition, as shown in FIG. 36.

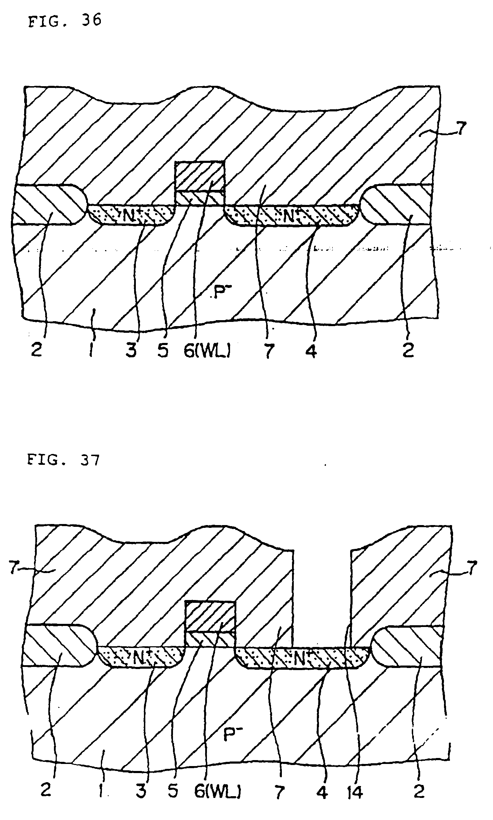

Next, contact hole 14 is formed with respect to SiO₂ insulation layer 7 according to photolithography on source region 4, as shown in FIG. 37.

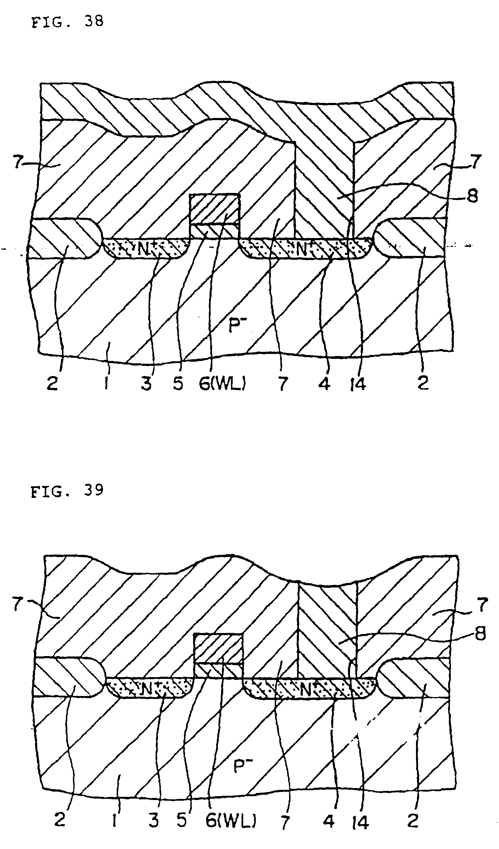

Next, polysilicon layer 8 is adhered so as to be embedded in contact hole 14 by contacting source region 4 by chemical vapor deposition, as shown in FIG. 38.

Next, polysilicon layer 8 is etched back and is left as a storage node by being embedded in contact hole 14, as shown in FIG. 39.

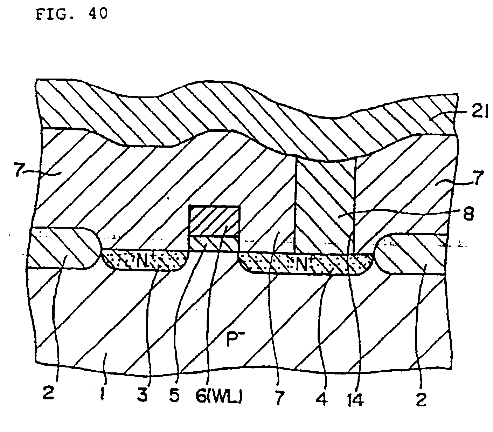

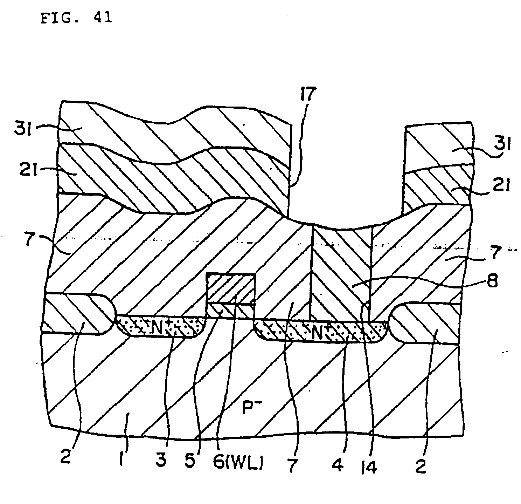

Next, it is important from here that SiO₂ insulation layer 21 is adhered to the entire surface by chemical vapor deposition, as shown in FIG. 40. Then, elimination part 17 is formed by etching insulation layer 21 with photoresist 31 as a mask by photolithography, as shown in FIG. 41.

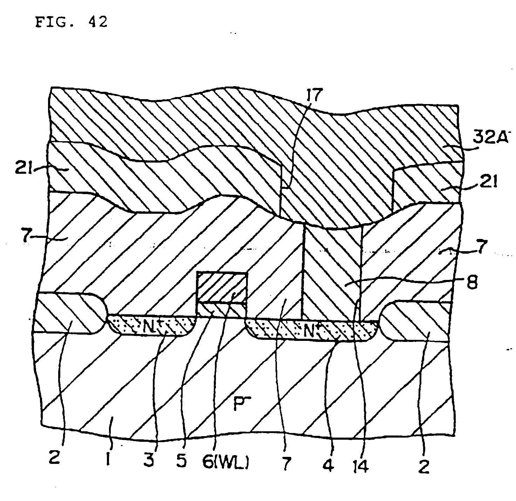

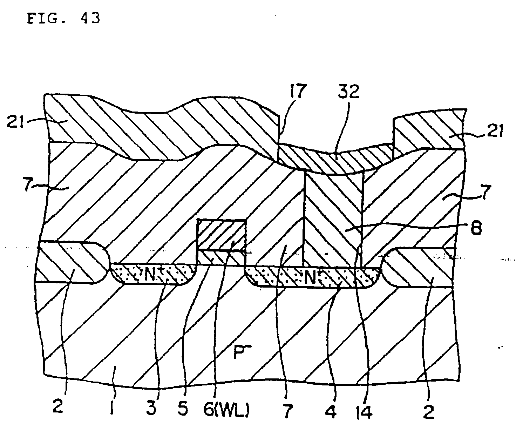

Next, after adhering a material for barrier metal layer 32A composed of a TiN layer and Ti adhesive layer to the entire surface by vacuum vapor deposition, etc., as shown in FIG. 42, barrier metal layer 32 is formed in elimination part 17 of insulation layer 21 by etch back, as shown in FIG. 43.

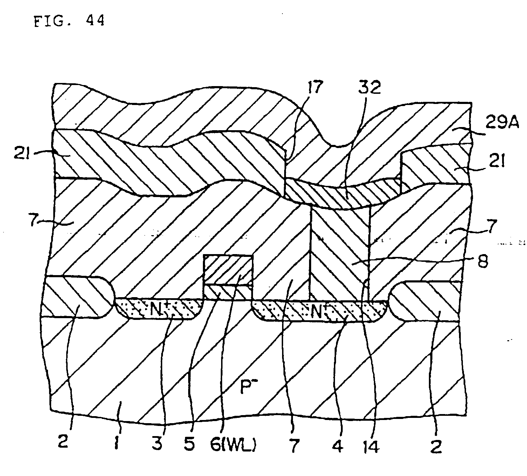

Next, bottom electrode material layer 29A composed of a Pt layer is formed on the entire surface by vacuum vapor deposition, etc., as shown in FIG. 44.

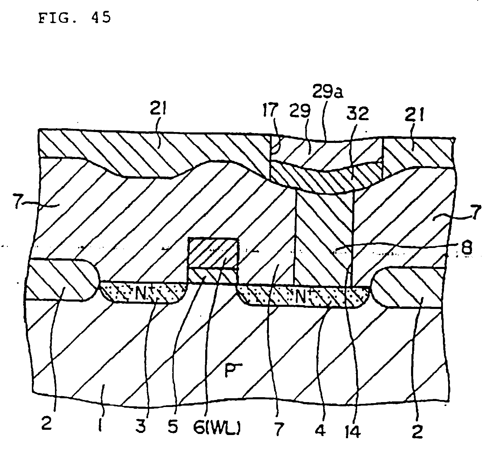

Next, by chemical-mechanical polishing (CMP) bottom electrode material layer 29A, bottom electrode 29 is formed so as to be embedded in elimination part 17 of insulation layer 21, as shown in FIG. 45. At this time, polishing by a chemical-mechanical polishing process is executed slightly more, so that the shape of bottom electrode 29 is formed to be smooth concave surface 29a. This bottom electrode 29 can be formed at a thickness of about 100 nm.

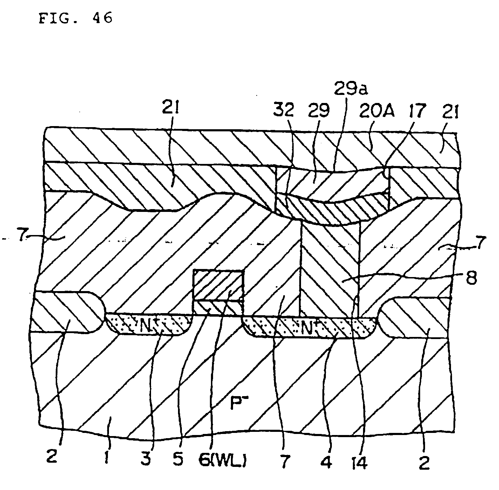

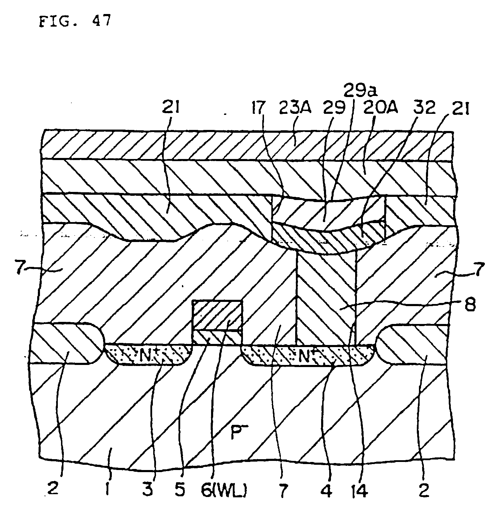

Next, high-dielectric film material 20A composed of BST is adhered by sputtering, etc., as shown in FIG. 46. On top of this, Pt layer 23A for the top electrode is adhered by vacuum vapor deposition, as shown in FIG. 47.

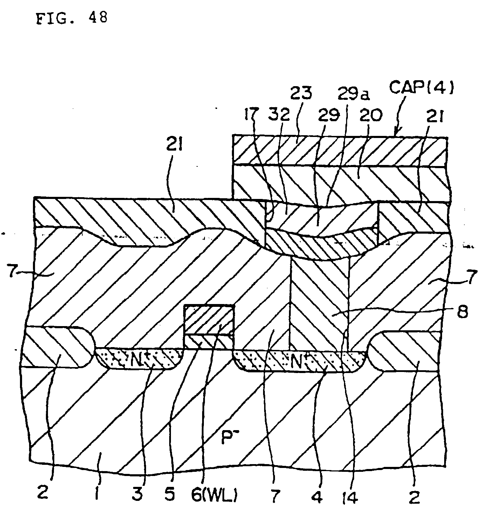

Next, top electrode material layer 23A and BST high-dielectric film material 20A are superimposed on approximately the same pattern, then etched, and top electrode 23 and BST high-dielectric film 20 with the same pattern are formed as shown in FIG. 48.

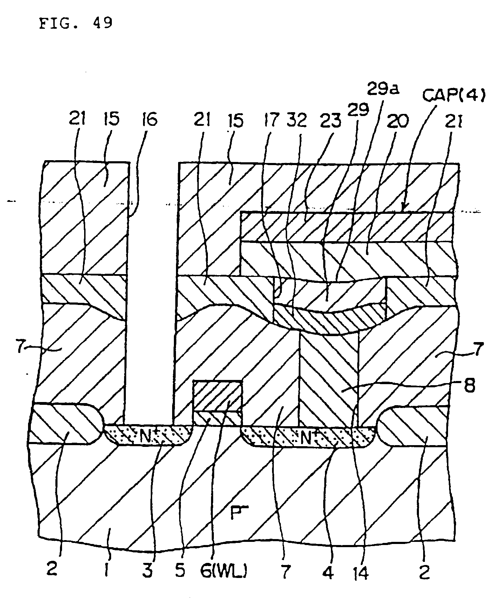

After thus fabricating high-dielectric capacitor CAP(4), interlayer insulation film 15 is formed by chemical vapor deposition (CVD), and contact hole 16 is formed in it as shown in FIG. 49. Furthermore, bit line 24 (BL) is formed as shown in FIG. 34 to fabricate memory cell M-CEL(4).

In this embodiment, the fact that with regards to the bottom electrode, bottom electrode 29 is embedded in through-hole 17 of insulation layer 21 by treating with a chemical-mechanical polishing process (CMP) and the surface has concave surface 29a is the same as the aforementioned embodiments; the aforementioned effects can be obtained.

Above, embodiments of the present invention were explained, but the aforementioned embodiments can be modified further based on the technological concept of the present invention.

For example, in the aforementioned embodiments, the bottom electrode material was adhered to include the elimination part provided by patterning the insulation film of silicon oxide film or titanium oxide film beforehand. This was applied with chemical-mechanical polishing, but it is possible to form the bottom electrode of smooth concave or convex shape as shown in FIG. 1 and FIG. 20 into a prescribed pattern, even if the bottom electrode material is etched back by plasma etching instead.

Also, the material property, shape, size, etc., of the dielectric film and electrode can be changed variously. For example, rare metals such as Ir, etc., can be used as the electrode in addition to Pt, and as the barrier metal, TaN, TaSiN, and TiAlN can be used. Also, even with regard to the structure, it is possible for the bottom electrode to be formed with a smooth convex shape in a (CUB-type) high-dielectric capacitor in which the high-dielectric capacitor part is provided under the bit line, for the bottom electrode to be formed with a smooth concave shape or convex shape in a (CUB-type) ferroelectric capacitor in which the ferroelectric capacitor part is provided under the bit line, etc. Various combinations can be considered such as the COB type or CUB type, shape of the bottom electrode (smooth concave shape or convex shape), etc., in the high-dielectric or ferroelectric capacitor. With regard to the top electrode, it is not always necessary to be etched into the same pattern as the dielectric film and can be etched separately.

Also, in a CUB-type dielectric memory device, the bit line can be arranged so as to be superimposed on the top part of the dielectric capacitor via an insulator or can be arranged not to be superimposed.

Furthermore, the present invention can naturally be applied to devices other than aforementioned DRAM and FRAM.

According to the present invention, an elimination part is patterned in the insulation film beforehand, so it is not necessary to pattern the first electrode. Namely, by treating the electrode material adhered to said elimination part with chemical-mechanical polishing, etch back, etc., a first electrode of prescribed shape can be obtained even if the first electrode is not patterned according to etching. Therefore, even if the first electrode is composed of a rare metal such as Pt, etd., it is not necessary to wet etch or dry etch this as in the conventional technology. Furthermore, there is no residue created during the etching, In addition, high integration can be achieved by making the electrode size small. Also, the first electrode is surrounded by an insulation film, so the top electrode and the dielectric film can be separated favorably between the cells. Favorable separation even between the top electrode and the bottom electrode is possible, so a dielectric capacitor and a memory cell of minimal current leakage and favorable insulation property can be obtained. Also, the second electrode can be processed into a prescribed shape with a margin according to wet etching.

Also, according to the present invention, by forming the elimination part of the insulation film into the electrode shape beforehand, the first electrode can be formed into a prescribed shape just by treating the electrode material from the surface. Thus, patterning of the first electrode by etching becomes unnecessary, and [the number of] processes in the electrode patterning in which etching is difficult is reduced by one, so economical and highly efficient manufacture is possible, such as reducing the cost and manufacturing time, etc.

Patterning of the insulation film (e.g., silicon oxide film or titanium oxide film) is much easier than patterning of an electrode composed of a rare metal such as platinum, etc., and the elimination part according to the design can be formed with favorable reproducibility.

Also, in the present invention, the first electrode is provided in the elimination part formed with an insulation film according to patterning beforehand. Thus, it is not necessary to flatten the backing part of the dielectric capacitor in the process for manufacturing a dielectric capacitor as in the conventional example (FIG. 54), and a side wall for insulation is not formed on the side surface of the first electrode. Therefore, the fabrication process count for the memory cell can be reduced further.

## Claims

1. A dielectric capacitor comprising a first electrode, a dielectric film formed by contacting said first electrode, a second electrode formed by contacting said dielectric film, and an insulation film provided by contacting the periphery of said first electrode, and to said insulation film, an elimination part is formed in a prescribed pattern, said first electrode adhered at least within said elimination part is processed into a prescribed shape so as to have a smooth surface, and said dielectric film is formed on this surface.

2. A dielectric capacitor of Claim 1, wherein the surface of the first electrode is processed into a smooth concave shape or convex shape by etch back or a chemical-mechanical polishing process.

3. A dielectric capacitor of Claim 1, wherein at least one part of said first electrode is embedded in the elimination part of the insulation film which was patterned beforehand.

4. A dielectric capacitor of one of Claims 1-3, wherein the first electrode is composed of a rare metal.

5. A dielectric capacitor of Claim 1, wherein the dielectric film is composed of a high-dielectric substance or ferroelectric substance.

6. A dielectric capacitor of Claim 5, wherein the dielectric film is a high-dielectric film and the insulation film is composed of a silicon oxide film.

7. A dielectric capacitor of Claim 5, wherein the dielectric film is a ferroelectric substance and the insulation film is composed of a titanium oxide film.

8. A dielectric capacitor of Claim 1, wherein the dielectric film and the second electrode are etched into the same pattern on the insulation film at the periphery of the first electrode.

9. A dielectric capacitor of Claim 1, wherein a barrier metal layer is provided at the bottom part of the first electrode.

10. A dielectric memory device having the dielectric capacitor of Claim in a memory cell.

11. A dielectric memory device of Claim 10, wherein a dielectric capacitor part is provided over or under the bit line.

12. A manufacturing method for dielectric capacitor, having a first electrode, a dielectric film formed by contacting said first electrode, a second electrode formed by contacting said dielectric film, and an insulation film provided by contacting the periphery of said first electrode, the processes comprising forming an elimination part by patterning said insulation film, adhering a material for said first electrode at least within said elimination part, making said first electrode into a prescribed shape having a smooth surface by treating the material for said first electrode from the surface, and the forming said dielectric film on this surface.

13. A manufacturing method of Claim 12, wherein the surface of the first electrode is formed into a smooth concave shape or convex shape by etch back or a chemical-mechanical polishing process.

14. A manufacturing method of Claim 12, wherein at least one part of the first electrode is formed in the elimination part of the insulation film which was patterned beforehand.

15. A manufacturing method of Claim 12, wherein the first electrode is formed of a rare metal.

16. A manufacturing method of Claim 12, wherein the dielectric film is formed of a high-dielectric substance or ferroelectric substance.

17. A manufacturing method of Claim 16, wherein the dielectric film is formed of a high-dielectric film and forms the insulation film with a silicon oxide film.

18. A manufacturing method of Claim 16, wherein the dielectric film is formed of a ferroelectric film and forms the insulation film with a titanium oxide film.

19. A manufacturing method of Claim 12, wherein the dielectric film and the second electrode are etched into the same pattern on the insulation film at the periphery of the first electrode.

20. A manufacturing method of Claim 12, wherein a barrier metal layer is provided at the bottom part of the first electrode.

21. A manufacturing method for dielectric memory device, wherein a dielectric capacitor in the memory cell is fabricated according to the manufacturing method of Claim 12.

22. A manufacturing method of Claim 21, wherein a dielectric capacitor part is provided over or under the bit line.
